(19) Europäisches Patentamt / European Patent Office / Office européen des brevets

(11) **EP 1 629 268 B1**

(12) **EUROPÄISCHE PATENTSCHRIFT**

(45) Veröffentlichungstag und Bekanntmachung des Hinweises auf die Patenterteilung:
**15.05.2013   Patentblatt 2013/20**

(21) Anmeldenummer: 04733618.5

(22) Anmeldetag: **18.05.2004**

(51) Int Cl.:
*G01N 23/22* *(2006.01)*       *G03F 7/20* *(2006.01)*

(86) Internationale Anmeldenummer:
**PCT/IB2004/050734**

(87) Internationale Veröffentlichungsnummer:
**WO 2004/104707 (02.12.2004 Gazette 2004/49)**

(54) **VERFAHREN UND VORRICHTUNG ZUM REINIGEN MINDESTENS EINER OPTISCHEN KOMPONENTE**

METHOD AND DEVICE FOR CLEANING AT LEAST ONE OPTICAL COMPONENT

PROCÉDÉ ET DISPOSITIF POUR NETTOYER AU MOINS UN COMPOSANT OPTIQUE

(84) Benannte Vertragsstaaten:
**AT BE BG CH CY CZ DE DK EE ES FI FR GB GR HU IE IT LI LU MC NL PL PT RO SE SI SK TR**

(30) Priorität: **22.05.2003   EP 03101475**

(43) Veröffentlichungstag der Anmeldung:
**01.03.2006   Patentblatt 2006/09**

(73) Patentinhaber:
• **Philips Intellectual Property & Standards GmbH
20099 Hamburg (DE)**
Benannte Vertragsstaaten:
**DE**
• **Koninklijke Philips Electronics N.V.
5621 BA Eindhoven (NL)**
Benannte Vertragsstaaten:
**AT BE BG CH CY CZ DK EE ES FI FR GB GR HU IE IT LI LU MC NL PL**

(72) Erfinder:
• **ZINK, Peter,
Philips Int. Prop. & Stand. GmbH
52066 Aachen (DE)**
• **PANKERT, Joseph,
Philips Int. Prop. & Stand. GmbH
52066 Aachen (DE)**
• **DERRA, Günther,
Philips Int. Prop. & Stand. GmbH
52066 Aachen (DE)**
• **WEBER, Achim,
Philips Int. Prop. & Stand. GmbH
52066 Aachen (DE)**

(74) Vertreter: **Volmer, Georg
Philips Intellectual Property & Standards GmbH
Postfach 50 04 42
52088 Aachen (DE)**

(56) Entgegenhaltungen:
**DE-A- 10 138 284       US-A1- 2002 084 425
US-A1- 2004 007 246     US-B1- 6 545 272**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung bezieht sich auf ein Verfahren zum Reinigen mindestens einer optischen Komponente von mindestens einer Bestrahlungseinrichtung, die in einer Vakuumkammer mindestens eine insbesondere extrem-ultraviolette und/oder weiche Röntgenstrahlung erzeugenden Strahlungsquelle aufweist, deren Strahlen über die optische Komponente auf ein zu bearbeitendes Werkstück geleitet werden, wobei die optische Komponente zumindest teilweise aufgrund einer durch die Strahlungsquelle eingebrachte anorganische Substanz mit Ablagerungen dieser Substanz rschmutzt wird.

Die Erfindung bezieht sich auch auf eine Vorrichtung nach dem Oberbegriff des Anspruchs 11.

Solche Strahlungsquellen werden insbesondere zur Belichtung von Wafern in einem lithographischen Produktionsprozess eingesetzt. Hierbei werden Strahlen von der Strahlungsquelle zum Wafer über eine Bestrahlungseinrichtung geleitet, die eine sehr teure und empfindliche Optik aufweist und beispielsweise Monochromatoren, Kollektorspiegel und Multi-Layer-Spiegel umfasst. Die Strahlungsquelle befindet sich dabei mit der Optik, einer Maske und dem Wafer in einer einzigen Vakuumkammer. Dies kann notwendig sein, da sonst die Strahlen durch beispielsweise Linsen, Fenster und einer Vielzahl von Gasen stark absorbiert werden würden.

Die Strahlungsquelle weist zum Erzeugen von Strahlen im Wellenlängenbereich von 10-20nm. bevorzugt etwa 13,5 nm, ein heißes Plasma auf, das beispielsweise durch elektrische Entladung oder Laserpulse vielfach ionisierte Ionen erzeugt, die im kurzwelligen Wellenlängenbereich Strahlen emittieren.

Bei Verwendung einer elektrischen Entladungseinrichtung werden aufgrund eines dabei eingesetzten Arbeitsgases, wie z.B. ein metallhaltiger Dampf, ständig überwiegend anorganische Substanzen in die Strahlungsquelle bzw. Vakuumkammer eingetragen. Zudem tritt während des Entladungsbetriebs häufig Elektrodenerosion auf, wobei metallhaltige Substanzen des naturgemäß elektrisch leitfähigen Elektrodenmaterials in die Vakuumkammer gelangen kann. Auch bei den laserinduzierten Plasmen werden sowohl durch ein vom fokussierten, gepulsten Hochleistungslaserstrahl anregbares anorganisches Target als auch durch die räumlich nahe dem Plasma angeordneten Düsen, die durch eine thermische Belastung und/oder aus dem Plasma stammenden Ionenbeschuss erodieren, ebenfalls anorganische Substanzen in die Vakuumkammer eingebracht.

Diese anorganischen Substanzen enthalten insbesondere Lithium, Zinn, Indium, Antimon, Tellur und/oder deren Kombinationen, die besonders effizient eine dem Plasma zugeführte Energie in Strahlen mit einer Wellenlänge von etwa 13,5 nm umwandeln können und unter den üblicherweise in der Belichtungseinrichtung vorherrschenden Druck- und Temperaturverhältnissen nicht flüchtig sind. Diese gelangen von der Strahlungsquelle zu den optischen Komponenten, dessen Reflektionsvermögen im EUV-Bereich drastisch durch Kondensieren der anorganischen Substanz unter Bildung von oberflächlichen Ablagerungen sinkt. Zudem treten Absorbtionsverluste durch die auf den optischen Komponenten abgeschiedenen Ablagerungen auf. Die Strahlen werden durch diese beiden Effekte so stark abgeschwächt, dass deren Intensität zu niedrig wird, um einen wirtschaftlich zu vertretenden Durchsatz von Wafern pro Zeiteinheit zu erzielen. Da die Ablagerungen auf der optischen Komponente nicht gleichmäßig verteilt auf einer der Reflexion der Strahlen dienenden Oberfläche auftreten, kommt es zu einer inhomogenen Inkusitätsverteilung der Strahlen und schließlich einer ungleichmäßigen Bestrahlung des Wafers.

Dieses Problem der Ablagerungen auf den optischen Komponenten einer Bestrahlungseinrichtung tritt auch durch kohlenstoffhaltige Verbindungen auf, die beispielsweise durch organische Materialien, wie dem Vakuumöl und/oder dem Photolack in die Vakuumkammer gelangen können.

Eine Reihe von Verfahren und Vorrichtungen zum Entfernen solcher kohlenstoffhaltiger Ablagerungen sind bekannt. So wird beispielsweise in der DE-A-100 61 248 kontrolliert Sauerstoff in die Vakuumkammer eingelassen, um eine in-situ Dekontamination eines EUV-Lithographiegerätes zu erreichen. Von besonderem Nachteil ist hierbei, dass der zugeführte Sauerstoff hauptsächlich nur die kohlenstoffhaltigen Ablagerungen oxidativ abbauen kann und insbesondere durch Umsetzung mit den anorganischen Substanzen beispielsweise nur Metalloxide gebildet werden, die unter den in der Vakuumkammer herrschenden Druck- und Temperaturverhältnissen geringe Dampfdrücke aufweisen. Weiterhin reagieren Oberflächen eines Ruthenium-Spiegels und/oder eine Molybdänschicht eines Multi-Layer-Spiegels irreversibel unter vollständigem Verlust der Reflektivität mit dem kaum zu vermeidenden Kohlenstoffmonoxid unter Bildung von teilweise flüchtigen Metallcarbonylen wie dem $Mo(CO)_6$.

Die WO-A-02/054 115 offenbart eine weitere Vorrichtung zum Reinigen eines Multi-Layer-Spiegels zur Verwendung in der EUV-Lithographie, bei der eine zusätzliche Schutzschicht aus beispielsweise Ruthenium, Rhodium, Palladium, Iridium, Platin und/oder Gold aufgebracht wird. Durch ein wahlweises Zuführen von molekularen Wasserstoff werden nur kohlenstoffhaltige Ablagerungen wirksam entfernt. Zudem Absorbieren die sauerstoffhaltigen Reaktionspartner, wie beispielsweise Wassermoleküle, die EUV-Strahlen beträchtlich. Die Intensität der Strahlen wird hierdurch naturgemäß besonders nachteilig reduziert.

Der Erfindung liegt somit die Aufgabe zugrunde, ein Verfahren bzw. eine Vorrichtung der eingangs genannten Art anzugeben, die mit technisch einfachen Mitteln zu einer deutlich verbesserten Entfernung von hauptsächlich anorgangischen Ablagerungen bzw. zu einer höheren Lebensdauer der optischen Komponenten führen.

Diese Aufgabe wird bei einem Verfahren nach Anspruch 1 und mit einer vorrichtung nach Anspruch 11 erfindungsgemäß dadurch gelöst, dass mindestens ein bezüglich der Strahlen im wesentlichen durchsichtiger bzw. transparenter Reaktionspartner in Abhängigkeit von den herrschenden Reaktionsbedingungen über eine Zuführungseinrichtung eingelassen wird, der mit den verschmutzenden Ablagerungen zum Zwecke deren Beseitigung von der optischen Komponente chemisch reagiert.

Für die Erfindung ist dabei die Erkenntnis von besonderer Bedeutung, dass dieses Verfahren sowohl für die laserinduzierten sowie auch für die Entladungsplasmen verwendbar ist. Ein durch die chemische Reaktion gebildetes Produkt kann beispielsweise unter den in der Bestrahlungseinrichtung vorherrschenden Druck- und Temperaturverhältnissen beispielsweise eine mobile Phase bilden, die der natürlichen Schwerkraft gehorchend von einer Oberfläche der optischen Komponente abfließt.

Um insbesondere eine hohe Umwandlungseffizienz einer in die Strahlungsquelle eingespeisten Energie zu erreichen, kann das Verfahren so verbessert werden, dass als die eingebrachte anorganische Substanz, vorzugsweise eine metallhaltige, insbesondere zinnhaltige Substanz verwandt wird.

Durch die relativ hohe optische Transmission des zugeführten Reaktionspartners tritt keine nennenswerte Absorption der Strahlen im EUV-Bereich auf. Somit wird das Verfahren vorteilhafterweise so aufgeführt, dass der Reaktionspartner während des Betriebs der Bestrahlungseinrichtung zugeführt wird. Auch ist eine Reinigung der optischen Komponenten nach Abschalten der Strahlungsquelle möglich, wobei eine Demontage der in der Vakuumkammer angeordneten optischen Komponenten nicht erforderlich ist und eine entsprechende Wartungszeit erheblich verkürzt wird.

Vorzugsweise ist das Verfahren so gestaltet, dass ein ausgewählter Reaktionspartner zu einer chemische Reaktion mit der anorgangischen Substanz und/oder den Ablagerungen führt, die ein unter den herrschenden Reaktionsbedingungen flüchtiges Reaktionsprodukt bildet.

Selbstverständlich ist unter einem flüchtigen Reaktionsprodukt eine Verbindung zu verstehen, die einen niedrigeren Siedepunkt bzw. eine niedrigere Sublimationstemperatur als die anorganische Substanz aufweist. Die umgewandelten Ablagerungen gehen in die Dampfphase über und können bequem durch eine an die Vakuumkammer angeschlossene Pumpe abgesaugt werden.

Um bei einer hohen Ablagerungsrate das Reflektionsvermögen einer optischen Komponente möglichst rasch wiederherzustellen, wird das Verfahren derart ausgeführt, dass der Reaktionspartner nach dem Gesichtspunkt einer schnellen chemischen Reaktion mit der anorganischen Substanz und/oder den Ablagerungen unter den herrschenden Reaktionsbedingungen ausgewählt und zugeführt wird.

Hierdurch kann eine Kontamination der optischen Komponente zeitnah unter allen Betriebszuständen der Strahlungsquelle entfernt werden.

Eine vorteilhafte Weiterbildung des Verfahrens sieht vor, dass zur Erzielung einer selektiven chemischen Reaktion mit der anorganischen Substanz und/oder den Ablagerungen ein ausgewählter Reaktionspartner zugeführt wird. Insbesondere durch eine höhere Selektivität des ausgewählten Reaktionspartners können Nebenreaktionen, wie beispielsweise Halogenierungen von anderen Bauteilen der Bestrahlungseinrichtung vermieden werden, wodurch die Betriebszeiten der Spiegel und Masken, der Vakuumkammer und der Pumpe deutlich steigen.

Das Verfahren wird vorteilhafterweise so ausgeführt, dass als Reaktionspartner beispielsweise eine wasserstoffhaltige Substanz und/oder ein Halogen, eine Interhalogen-, eine halogenhaltige Verbindung und/oder eine Kombination daraus verwandt werden. Durch die wasserstoffhaltige Substanz, die ohne sie darauf zu beschränken molekularer Wasserstoff, Halogenwasserstoff oder auch Ammoniak sein kann, werden insbesondere mit anorganischen Substanzen flüchtige Hydride, wie z.B. $H_2Te$ gebildet. Unter den Halogenen ist neben elementarem Fluor, Brom, Jod vor allem Chlor besonders zu erwähnen, da dieses Element trotz einer relativ hohen Reaktivität gegenüber anorganischen Substanzen gut handhabbar ist. Sowohl die Interhalogenverbindung, für die hier beispielhaft $ClF_3$ genannt sein soll, und die halogenhaltigen Verbindungen, beispielsweise $NF_3$, können dabei als alternative Fluorquelle verwandt werden.

Von besonderem Vorteil für das Verfahren ist, wenn der Reaktionspartner in der Vakuumkammer durch die Strahlen und/ oder durch Bestrahlen mittels einer zusätzlichen Anregungseinrichtung in Radikale umgewandelt wird. Diese werden beispielsweise bei Bestrahlung im EUV-Bereich in-situ aus den vorgenannten Verbindungsklassen in der Bestrahlungseinrichtung gebildet. Um eine höhere Konzentration an besonders reaktiven Radikalen gezielt erreichen zu können, kann die zusätzliche Anregungseinrichtung beispielsweise UV Licht mit geeigneter Wellenlänge auf die zu reinigende optische Komponente leiten, wobei der zugeführte molekulare Reaktionspartner Radikale bildet.

Vorzugsweise ist das Verfahren derart gestaltet, dass der Reaktionspartner in flüssiger und/oder gasförmiger Form zugeführt wird. Der ausgewählte Reaktionspartner kann hierbei mit geringem technischen Aufwand in die Vakuumkammer eingebracht werden.

Durch eine kombinierte Zuführung von gasförmigen und flüssigen Reaktionspartnern lässt sich zudem ein relativ dichter Nebel mit Tröpfchen von geeigneter Größe erzeugen, die beispielsweise die optischen Komponenten kurzzeitig benetzen können. Somit werden zeitlich und räumlich begrenzt hohe Konzentrationen des Reaktionspartners in der Nähe der Ablagerungen erreicht, um beispielsweise bei einer niedrigen Reaktionsrate und hoher Selektivität eine gute Reinigung der optischen Komponente zu erreichen.

Von besonderem Vorteil für das Verfahren ist, wenn der Reaktionspartner ständig während des Betriebs zugeführt wird. Dies führt beispielsweise bei einer kontinuierlichen Zuführung des Reaktionspartners zu konstanten Fluss- und Druckverhältnissen in der Bestrahlungseinheit. Zudem kann sich ein chemisches Gleichgewicht zwischen Reaktionspartner, der anorganischen Substanz bzw. den Ablagerungen und den Reaktionsprodukten einstellen.

Vorteilhafterweise wird das Verfahren derart weitergebildet, dass der Reaktionspartner portionsweise, beispielsweise durch einen gepulsten Einlass, zugeführt wird. Hierdurch kann insbesondere bei bekannter Reaktionskinetik eine durch den zugeführten Reaktionspartner initiierte Umsetzung mit den Ablagerungen eine optimierte Reingungsrate auf den optischen Komponenten erreicht werden.

Das Verfahren wird dabei so ausgeführt, dass entweder der Reaktionspartner im Überschuss bezüglich einer eingetragenen Menge an anorganischer Substanz und/oder den Ablagerungen zugeführt wird, wobei der Überschluss an Reaktionspartner dabei zeitlich und räumlich so begrenzt zugeführt wird, dass in Abhängigkeit von der Reaktionskinetik der chemischen Reaktion mit der anorganischen Substanz ein Reaktionsprodukt gezielt gebildet wird, oder

dass der Reaktionspartner mit einer Rate bis zur chemischen Äquivalenz bezüglich einer eingetragenen Menge an anorganischer Substanz und/oder Ablagerungen über eine Dosiereinrichtung zugeführt wird. Die Dosiereinrichtung ermöglicht beispielsweise den gepulsten Einlass eines Reaktionspartners und senkt durch eine der Reaktionskinetik angepassten Zuführung des Reaktionspartners den Materialaufwand erheblich.

Das Verfahren kann weiterhin dadurch verbessert werden, dass die zuzuführende Menge an Reaktionspartner in Abhängigkeit von einer Intensität des die optische Komponente verlassenden Strahlen festgelegt wird, wobei die Intensität über mindestens eine Messeinrichtung bestimmt wird. Hierzu kann natürlich jede in der Fachwelt bekannte Messeinrichtung wie beispielsweise eine Diode mit angepasstem Filter eingesetzt werden. Selbstverständlich ist es auch noch möglich, alternativ eine Messeinrichtung zur Bestimmung des Eintrags an anorganischer Substanz einzusetzen. Letztere Messeinrichtung misst beispielsweise die Menge des direkt auf die optische Komponente auftreffenden Materials.

Zur weiteren Steigerung der Effizienz der Reinigung der optischen Komponente wird das Verfahren vorzugsweise derart ausgeführt, dass der Reaktionspartner über eine Zuleitung der Zuführungseinrichtung räumlich nahe zu der optischen Komponente zugeführt wird. Durch die zusätzliche Zuleitung kann der Reaktionspartner gezielt in die Bestrahlungseinrichtung eingelassen werden.

Ein besonders vorteilhaftes Verfahren ist so gestaltet, dass der Reaktionspartner auf die optische Komponente fokussiert wird. Hierbei trifft ein Großteil des zugeführten Reaktionspartners auf eine vollreflektierende Oberfläche der optischen Komponente, wodurch eine vollständige Umsetzung der Ablagerung in eine flüchtige Verbindung sichergestellt werden kann.

Das Verfahren kann vorteilhafter Weise so weitergebildet werden, dass die Zuführungseinrichtung den Reaktionspartner aufteilt und sektoriert zuführt. Da die optischen Komponenten aufgrund ihrer räumlichen Anordnung in der Bestrahlungseinrichtung lokal unterschiedlich durch die Ablagerungen verschmutzt werden, wird durch Aufteilen des Reaktionspartners eine gezieltere Zuführung erreicht und Nebenreaktionen mit beispielsweise der Vakuumkammer vermieden.

Das Verfahren kann zudem dadurch verbessert werden, dass der Reaktionspartner über eine Kühlung und/oder Düse in die Vakuumkammer zugeführt wird. Insbesondere gasförmige Reaktionspartner können durch eine technisch einfach zu realisierende Kühlung bzw. eine Düse unter Ausnutzen des Joule-Thompson-Effekts verflüssigt werden, um eine ausreichende Verweildauer des Reaktionspartners in der Bestrahlungsrichtung bzw. auf der Oberfläche der optischen Komponente sicherzustellen.

Ein besonders vorteilhaftes Verfahren zum Reinigen von optischen Komponenten einer Bestrahlungseinrichtung ist so gestaltet, dass mindestens eine optische Komponente mit einer im Hinblick für die Strahlen im wesentlichen transparenten Beschichtung versehen ist. Unter einer transparenten Schicht ist eine Schicht bis zu einer Dicke von einigen Nanometern zu verstehen. Als Material hierfür kommen beispielsweise Platin, Palladium, Gold, Ruthenium, Nickel, Rhodium oder dessen Legierungen oder Verbindungen, wie z.B. Oxide oder Nitride in Frage, aber auch $SiO_2$ oder Kohlenstoff. Diese Beschichtungen schützen dabei zusätzlich die reflektierenden Oberflächen der optischen Komponente vor dem zugeführten Reaktionspartner.

Vorzugsweise wird das Verfahren derart gestaltet, dass die optische Komponente durch eine Heizeinrichtung auf eine Temperatur von Raumtemperatur bis etwa 800°C, vorzugsweise auf etwa 400°C erhitzt wird. Für die Reinigung von zinnhaltigen Ablagerungen hat sich eine Temperatur von etwa 50°C bis etwa 300°C als besonders geeignet erwiesen. Da mit steigender Temperatur der optischen Komponente bei gleichen Druck- und Temperaturverhältnissen in der Bestrahlungseinrichtung der Dampfdruck von der anorganischen Substanz, deren Ablagerungen und des daraus gebildeten Reaktionsproduktes steigen, ist die Ablagerung der anorganischen Substanz emiedrigt sowie die Abdampfrate des Reaktionsproduktes erhöht. Weiterhin steht eine größere Auswahl von Reaktionsprodukten zur Verfügung, die bei einer erhöhten Temperatur zumindest in flüssiger Form vorliegen. Selbstverständlich kann die Temperatur der optischen Komponenten nur unter Berücksichtigung von den Materialeigenschaften der optischen Komponente, und sich naturgemäß bei steigenden Temperaturen verschiebenden Reaktionsgleichgewichten gewählt werden.

Eine Weiterbildung der Erfindung sieht vor, dass die Reinigung in der Betriebspause der Bestrahlungseinrichtung ohne Demontage einzelner Komponenten durchgeführt wird. Dies wird als Offline-Reinigung bezeichnet.

Dabei ist es von Vorteil, wenn die Reaktionsparameter, Temperatur - und Partialdruck, des Reaktionspartners bzw. der Reinigungsgase bezüglich einer hohen Abtragsrate des Debris-Materials oder bezüglich einer hinsichtlich des Materials der optischen Komponenten schonenden Reinigung optimiert werden.

Damit die Reinigung noch effektiver erfolgen kann, beispielsweise auch durch für nicht zu reinigende Bestandteile schädliche Überdosen, ist es vorteilhaft, wenn nicht zu reinigende Komponenten der Bestrahlungseinrichtung vor einer Beaufschlagung mit dem Reaktionspartner bzw. dem Reinigungsgas geschützt werden.

Besonders vorteilhaft ist gemäß einer Weiterbildung der Erfindung vorgesehen, dass der Reaktionspartner in Abhängigkeit von der Reaktion mit dem deponierten Metall ausgewählt wird.

Damit Partialdrücke von halogenhaltigen und/oder wasserstoffhaltigen Substanzen jeweils nur am Ort der gewünschten Reinigung erhöht und sonst ausreichend gering sind, ist es vorteilhaft, wenn die Partialdrücke der halogenhaltigen und/ oder wasserstoffhaltigen Reaktionspartner jeweils nur am Ort der gewünschten Reinigung erhöht werden.

Dazu ist es insbesondere im sogenannten Offline-Betrieb vorteilhaft, wenn die zu reinigenden optischen Komponenten für die Dauer des Reinigungsvorgangs vom übrigen Vakuumsystem getrennt werden. Dadurch werden im wesentlichen nur die optischen Komponenten mit dem Reaktionspartner beaufschlagt.

Ein Schutz von nicht zu reinigenden Oberflächen ist dann vorteilhaft erzielbar, wenn in Bereiche des Vakuumsystems, die nicht mit dem Reinigungsgas behandelt werden sollen, Inertgas zugeführt wird, und/oder der Reaktionspartner als Gemisch mit einem Inertgas eingebracht wird.

Gemäß einer Weiterbildung der Erfindung ist es vorgesehen, dass mit Ausnahme der optischen Komponenten die übrigen Bestandteile durch lokale Zugabe zusätzlicher Reaktionsgase chemisch passiviert oder flüchtige in nicht flüchtige Substanzen überführt werden, wobei als ein Reaktionsgas z.B. Sauerstoff oder Wasserstoff gewählt werden kann.

Durch die vorgenannten Maßnahmen wird auch die Freigabe flüchtiger Verbindungen von nicht zu reinigenden Komponenten in die Gasphase und eine damit verbundene negative Beeinflussung der Vakuumqualität unterdrückt.

Wie zuvor beschrieben, kann beim Betrieb eines Quellensystems mit metallischen Arbeitsmedien der Kollektor mit Hilfe der chemischen Reinigung von metallischen Ablagerungen frei gehalten werden. Es kann ein wirtschaftlich effizienterer Langzeitbetrieb dann erreicht werden, wenn in das System eine Einrichtung zur Debris-Unterdrückung zwischen Strahlungsquelle und Kollektor integriert wird.

Damit die Menge der zu beseitigenden Ablagerungen verringert werden kann, ist es daher bei einem Verfahren nach dem Oberbegriff des Anspruchs 1 vorteilhaft, wenn die eingebrachten anorganischen Substanzen zwischen der Strahlungsquelle und dem Kollektor mittels einer Folienfalle unterdrückt: werden.

Dabei ist es besonders vorteilhaft, wenn die Folienfalle mit einem Puffergas beaufschlagt wird.

Damit die Lebensdauer der Folienfalle erhöht wird, ist es vorteilhaft, wenn die Folienfalle analog zu der optischen Komponente, aber getrennt davon chemisch gereinigt wird.

Besonders vorteilhaft ist dabei, wenn die Reinigung unter Durchfluss des Reinigungsmediums dynamisch oder bei Abschluss des Systems, insbesondere der optischen Komponente, statisch durchgeführt wird.

Der Reinigungsvorgang der Folienfalle kann dadurch erhöht werden, dass die Folienfalle zusätzlich beheizt wird.

Eine weitere Erhöhung des Reinigungserfolges ist möglich, wenn der Reinigungspartner lediglich in ein die Folienfalle enthaltendes Teilvolumen des Vakuungefäßes eingeleitet wird.

Es ist zudem auch möglich, dass die Folienfalle mechanisch gereinigt wird.

Gemäß einer Weiterbildung der Erfindung ist es vorgesehen, dass die Folienfalle oder ein Teil der Folienfalle in Rotation versetzt wird.

Zur Erhöhung der Lebensdauer der optischen Komponenten des Quellmoduls ist es vorteilhaft, wenn Sperrgas mit einer vom Puffergas der Folien-falle verschiedenen Gasart im Bereich der Strahlungsquelle und/oder im Bereich des Kollektors zusätzlich zugeführt wird.

Eine weitere Möglichkeit dafür besteht darin, dass zur Unterdrückung von Ablagerungen elektrische und/oder magnetische Felder angelegt werden.

Damit Sekundärentladungen im Kollektorraum vermieden werden, ist es vorteilhaft, wenn zumindest während des Betriebs der Lampe die Folienfalle und/oder der Kollektor gegenüber dem Vakuumgefäß elektrisch isoliert wird/ werden.

Da für das Reinigungsverfahren eine besonders exakte Dosierung aller dazu beitragenden Komponenten für einen optimalen Erfolg benötigt wird, ist es vorteilhaft, wenn es elektronisch gesteuert wird.

Für die Steuerung des Quellmoduls mit allen Komponenten zur Reinigung des Systems im Online- oder Offline-Betrieb wird ein komplexes Steuer- und Regelungssystem verwandt, das den Zustand der optischen Komponenten und der Systeme zur Debris-Unterdrückung überwacht und die Reinigungsprozesse initialisiert und steuert.

Eine wichtige Komponente des Regelungssystems ist die ständige Messung des Verschmutzungsgrads der optischen Komponenten, zum Beispiel des Kollektors. Die Messung sollte bevorzugt an verschiedenen Stellen erfolgen, da der Verschmutzungsgrad ortsabhängig sein kann, und damit auch die Detektion, die Prozesssteuerung der Reinigung und die Erfolgskontrolle lokal erfolgen müssen.

Ein geeigneter Messparameter hierfür ist zunächst die Reflektivität der optischen Komponenten, möglichst bei der Wellenlänge des Lithographieprozesses, zum Beispiel EUV-Bereich, und möglichst auch unter dem für die optischen Komponenten typischen Einfallswinkel. Hierzu können zum Beispiel in Belichtungspausen, wie sie beim Wechsel von Wafern entstehen, geeignete EUV-Detektoren, wie zum Beispiel Photodioden mit speziellen Filtern, in die Nähe der optischen Komponenten gebracht werden, um die Intensität des an verschiedenen Stellen der optischen Komponenten reflektierten Lichtes zu messen.

Es ist auch möglich, Strahlung anderer Wellenlänge, wie zum Beispiel sichtbare Strahlung, zu verwenden, um über Änderungen der Reflektivität Depositionen auf den optischen Komponenten zu messen. Dies ist besonders vorteilhaft, wenn bei der Offline-Reinigung keine EUV-Quelle zur Verfügung steht.

Es gibt noch weitere Messprinzipien, die sowohl bei Online-Reinigung als auch bei Offline-Reinigung zur Messung von deponierten Schichten eingesetzt werden können. Mit Schichtdickenmessverfahren, wie z. B. Schwingquarzen oder auch ellipsometrischen Methoden können Vorhandensein und Dicke von Verunreinigungsschichten gemessen werden.

Durch Anlegen hochfrequenter Wechselspannung an die Oberfläche der optischen Komponenten kann deren elektrische Oberflächenleitfähigkeit bestimmt werden. Diese ist materialabhängig und lässt auf Oberflächenbelegungen zurückschließen. Sind die Leitfähigkeitsunterschiede zwischen dem Oberflächenmaterial und dem deponierten Material zu gering, so können in Nähe einer optischen Komponente Flächen eines Materials mit großem Leitfähigkeitsunterschied zur Verunreinigung (zum Beispiel Isolatormaterialien bei metallischen Verunreinigungen) angebracht werden, die in räumlicher Orientierung und Oberflächentemperatur der optischen Komponente ähneln. Damit lassen Depositionen auf diesen Messflächen direkt auf Depositionen auf der optischen Komponente zurückschließen.

Ein weiterer Messparameter ist ein Photostrom, der dadurch entsteht, dass Strahlungsquanten, die auf die Oberfläche einer optischen Komponente treffen, zu Elektronenemission führen. Auch Veränderungen in diesem Photostrom sind empfindliche Hinweise auf Änderungen der Oberflächenbelegung mit einer Verunreinigung.

Die Analyse der Gasphase im Vakuumsystem an unterschiedlichen Stellen liefert wertvolle Aufschlüsse zur Steuerung der chemischen Reinigung. Es gibt verschiedene Messverfahren, mit denen diese Analyse möglich ist. Als Beispiel sei hier vor allem die Massenspektrometrie genannt. Durch Messung der Partialdruckzusammensetzung können sowohl die flüchtigen Reaktionsprodukte als auch überschüssige Reaktionsgase nachgewiesen werden. Dies dient zum einen der Optimierung der Reinigungseffizienz. Es wird z.B. bei einer möglichst schonenden Reinigung das Verhältnis der Partialdrucke von Reaktionsprodukt und Reaktionsgas maximiert. In einem anderen Beispiel wird für eine möglichst schnelle Reinigung der Partialdruck des Reaktionsproduktes maximiert. Bei Offline-Reinigung kann das Reinigungsende durch Abnahme des Partialdruckes des Reaktionsproduktes nachgewiesen werden. Durch Partialdruckmessungen kann auch die Selektivität überwacht werden, indem nicht gewollte Reaktionsprodukte mit dem Material der optischen Komponente überwacht werden. In ähnlicher Weise kann die Vakuumqualität hinsichtlich Verunreinigungen durch Reaktionen mit anderen Komponenten des Vakuumsystems kontrolliert werden. Schließlich können über die Partialdruckmessungen die Regenerationszyklen von Sorptionspumpen gesteuert werden.

Die Steuerung der Gaszuführung von Reaktionsgasen kann über Ventile und Flusssteuerungen mit entsprechenden Flussmessern erfolgen. Dabei wird der resultierende Druck des Reaktionsgases durch lokale Partialdruckmessungen kontrolliert. Bei Reinigung mit Überschuss des Reaktionsgases genügt eine lokale Gesamtdruckmessung. Das Steuersystem für die Gaszufuhr erlaubt die Wahl zwischen unterschiedlichen Reaktionsgasen, die lokale Verteilung der Reaktionsgase, die Beimischung von Inertgas zur Diffusionsminderung und die Zuführung von zusätzlichen Reaktionsgasen zur Passivierung nicht zu reinigender Oberflächen.

Neben dem Gaseinlass stellen natürlich die Temperaturen sowohl der zu reinigenden als auch der nicht zu reinigenden Komponenten wichtige Steuerparameter dar. Außerdem wird die chemische Reinigung über die Dauer der Exposition mit dem Reaktionsgas gesteuert.

Die Zuführungseinrichtung für die zuführung des reaktions partners kann insbesondere so an der Bestrahlungseinrichtung angeordnet werden, dass der Reaktionspartner in Sogrichtung der Vakuumkammer vor der ersten optischen Komponente und nach der Strahlungsquelle zuführbar ist. Selbstverständlich ist die Verschmutzung der zur Strahlungsquelle räumlich nächststehenden optischen Komponente am höchsten. Durch eine erhöhte Konzentration des Reaktionspartners in diesem Bereich kann so eine relativ hohe Umsetzungsrate zu insbesondere flüchtigen Reaktionsprodukten erreicht werden.

Vorteilhafterweise ist die Vorrichtung so ausgeführt, dass als die eingebrachte anorganische Substanz, vorzugsweise eine metallhaltige, insbesondere zinnhaltige Substanz verwendbar ist. Durch Einbringen von beispielsweise zinnhaltigen Substanzen in die Strahlungsquelle kann ein höherer Wirkungsgrad bei einer Umwandlung von zugeführter Energie in Strahlungsintensität erreicht werden.

Die Vorrichtung kann dabei so weitergebildet werden, dass der Reaktionspartner während des Betriebs der Bestrahlungseinrichtung zuführbar ist. Hierbei ist von besonderem Vorteil, dass in-situ die Zuführung des Reaktionspartners erfolgen kann und eine kostenträchtige Demontage der Bestrahlungseinrichtung entfällt.

Eine besonders vorteilhafte Vorrichtung ist derart gestaltet, dass über die Zuführungseinrichtung für die chemische Reaktion mit der anorganischen Substanz und/oder den Ablagerungen zur Bildung eines unter den herrschenden Reaktionsbedingungen flüchtigen Reaktionsproduktes ein ausgewählter Reaktionspartner zuführbar ist. Das flüchtige Reaktionsprodukt wird anschließend durch die Vakuumkammer abgesaugt. Alternativ könnte das Reaktionsprodukt durch eine Abscheidevorrichtung wie beispielsweise eine Kühlfalle an geeigneter Stelle in der Vakuumkammer gesammelt bzw. abgeführt werden.

Mit zunehmender Entfernung von der Strahlungsquelle sinkt die Konzentration der anorganischen Substanz und somit die Menge an Ablagerungen auf den nachfolgenden optischen Komponenten.

Vorzugsweise ist die Vorrichtung so gestaltet, dass über die Zuführungseinrichtung der nach dem Gesichtspunkt einer schnellen chemischen Reaktion mit der anorganischen Substanz und/oder den Ablagerungen unter den herrschenden Reaktionsbedingungen benötigte Reaktionspartner auswählbar ist.

Die Zuführungseinrichtung ist hierzu beispielsweise inwandig mit Teflon beschichtet, um vor Korrosion geschützt zu werden. Weiterhin weist die Zuführungseinrichtung vorzugsweise mehrere räumlich getrennte Vorratsbehälter für die Bereitstellung verschiedener Reaktionspartner auf, die im Bedarfsfalle relativ zeitnah umgestellt werden können.

Um eine effektive Umsetzung zu erreichen, ist die Vorrichtung vorteilhafterweise so ausgestaltet, dass durch die Zuführungseinrichtung der zur Erzielung einer selektiven chemischen Reaktion mit der anorganischen Substanz und/oder den Ablagerungen unter den herrschenden Reaktionsbedingungen benötigte Reaktionspartner auswählbar ist.

Hierdurch sinkt insbesondere die Gefahr von Nebenreaktionen, die zwischen den zugeführten Reaktionspartnern und den Bauteilen der Bestrahlungseinrichtung, hauptsächlich der Oberfläche der optischen Komponente, extrem ab.

Hierzu kann die Vorrichtung derart weitergebildet werden, dass die Zuführungseinrichtung als Reaktionspartner beispielsweise eine wasserstoffhaltige Substanz und/oder ein Halogen, eine Interhalogen-, eine halogenhaltige Verbindung und/oder eine Kombination daraus eingibt. Insbesondere molekularer Wasserstoff und die elementaren Dihalogene Chlor, Brom und Fluor sind relativ transparent bezüglich der Strahlen im EUV-Bereich. Bei Verwendung von Fluor und/oder fluorhaltigen Verbindungen werden insbesondere die Oberflächen der Vakuumkammer naturgemäß passiviert und somit vor weiterer Korrosion geschützt.

Durch eine gezielte Auswahl des zugeführten Reaktionspartners kann unter den herrschenden Bedingungen in der Bestrahlungseinheit sichergestellt werden, dass die verschmutzenden Ablagerungen schneller reagieren, als beispielsweise ein Spiegelmaterial, wie zum Beispiel Ruthenium, Rhodium, Silizium und/oder Molybdän.

Eine erhöhte Reaktionsrate kann durch eine weitere Ausführungsform der Vorrichtung dadurch erreicht werden, dass der Reaktionspartner in der Vakuumkammer durch die Strahlen und/oder durch Bestrahlen mittels einer zusätzlichen Anregungseinrichtung in Radikale umwandelbar ist. Selbstverständlich wandeln sich einige Reaktionspartner bei Bestrahlung mit EUV-Licht bereits in Radikale um, die als besonders chemisch reaktive Fragmente vorzugsweise mit der anorganischen Substanz reagieren können. Durch die Anregungseinrichtung, die mittels Licht mit geeigneter Wellenlänge oder elektrischer Energie in Form beispielsweise einer stillen Entladung möglichst nahe der optischen Einrichtung zugeführt wird, kann die Bildung von Radikalen stark verbessert werden.

Vorteilhafter Weise ist die Vorrichtung derart ausgebildet, dass die Zuführungseinrichtung den Reaktionspartner in flüssiger und/oder gasförmiger Form bereitstellt. Die Zuführungseinrichtung kann hierbei im einfachsten Falle eine in der Größe variierbare Öffnung zwischen Vorratsbehälter des Reaktionspartners und der Bestrahlungseinrichtung aufweisen. Der Reaktionspartner wird dabei aufgrund der herrschenden Druckdifferenzen zwischen Vorratsbehälter und Vakuumkammer in die Bestrahlungseinheit quasi eingesaugt.

Die Vorrichtung ist hierzu zweckmäßiger Weise so ausgerüstet, dass über die Zuführungseinrichtung der Reaktionspartner ständig während des Betriebs zuführbar ist. Die Zuführung des Reaktionspartners sollte dabei sowohl an eine Verschmutzungsrate mindestens einer optischen Komponente als auch an zumindest eine Reaktionsrate angepasst werden können. Die Reaktionsrate ist von einer vom zugeführten Reaktionspartner und den Ablagerungen vorgegebenen Kinetik abhängig.

Eine bevorzugte Ausführungsform der Vorrichtung sieht daher vor, dass der Reaktionspartner portionsweise, beispielsweise durch einen pulsenden Einlass, zuführbar ist. Die Portionierung des Reaktionspartners kann natürlich durch jede in der Fachwelt bekannte Technik, beispielsweise durch eine Pumpe, Förderschnecke oder Scheiben erfolgen. Dies kann auch eine gepulste Zuführung des Reaktionspartners sein, bei der die Menge durch eine geeignete Pulsdauer der Zuführung des Reaktionspartners optimiert wird.

Die Vorrichtung ist so ausgelegt, dass entweder der Reaktionspartner im Überschuss bezüglich einer eingetragenen Menge an anorganischer Substanz und/oder der Ablagerungen zuführbar ist, wobei insbesondere die Reaktionsrate positiv beeinflusst werden, jedoch Der Überschuss dabei zeitlich und räumlich begrenzt zuführbar ist, oder dass über die Zuführungseinrichtung der Reaktionspartner mit einer Rate bis maximal zur chemischen Äquivalenz bezüglich einer eingetragenen Menge an anorganischer Substanz und/oder den Ablagerungen über eine Dosiereinrichtung zuführbar ist. Die Rate an zugeführtem Reaktionspartner wird wiederum hauptsächlich anhand der vorbekannten Reaktionskinetik gesteuert.

Vorzugsweise ist die Vorrichtung zum Reinigen einer optischen Komponente derart ausgeführt, dass die zuzuführende Menge an Reaktionspartner in Abhängigkeit von einer Intensität der die optische Komponente verlassenden Strahlen festlegbar ist, wobei die Intensität über eine Messeinrichtung bestimmbar ist. Die Strahlen können hierzu beispielsweise bei Wechsel des Wafers und/oder der Maske durch einen beweglichen Spiegel auf beispielsweise einen Sekundärelektronenvervielfacher oder jede andere hierfür geeignete Messeinrichtung umgelenkt werden, um das Reflektionsvermögen einer einzigen optischen Komponente oder des gesamten optischen Systems der Bestrahlungseinrichtung zu bestimmen. Weiterhin kann eine Messeinrichtung in der Strahlungsquelle vorgesehen werden, die die direkt auf die optische Komponente treffende Menge an anorganischer Substanz detektiert, um die zuzuführende Menge an Reaktionspartner zu ermitteln.

Vorzugsweise ist die Vorrichtung so ausgelegt, dass die Zuführungseinrichtung räumlich nahe zu der optischen Komponente eine Zuleitung aufweist. Neben einer vereinfachten Stromführung des zugeführten Reaktionspartners in der Bestrahlungseinrichtung kann dadurch eine zusätzliche Senkung der Absorption der Strahlen durch das Reaktionsprodukt erreicht werden.

Um eine erhöhte Konzentration des Reaktionspartners auf der optischen Komponente zu gewährleisten, ist die Vorrichtung vorteilhafterweise so ausgebildet, dass über eine bzw. die Zuleitung der Zuführungseinrichtung der Reaktionspartner auf die optische Komponente fokussierbar ist. Zusätzlich kann ein Trägergasstrom beispielsweise aus Wasserstoff oder Stickstoff verwandt werden, der das flüchtige Reaktionsprodukt von der reflektierenden Oberfläche der optischen Komponente wegbläst.

Um eine naturgemäß variierende Menge an Ablagerungen auf der Oberfläche einer optischen Komponente bzw. den optischen Komponenten des optischen Systems effizienter zu reinigen, kann die Vorrichtung derart verbessert werden, dass die Zuführungseinrichtung zum Aufteilen der Menge an Reaktionspartner Sektoren aufweist. Die Sektoren können hierzu sowohl am Ende der Zuleitung als auch an den Abzweigungsstellen zweier Zuleitungen angeordnet werden, um eine bessere Verteilung des zugeführten Reaktionspartners zu gewährleisten.

Zur weiteren Steigerung der Reinigungseffizienz kann die Vorrichtung derart weitergebildet werden, dass die Zuführungseinrichtung eine Kühlung und/oder eine Düse aufweist. Insbesondere durch diese Einrichtungen kann eine Zuführung von unter den herrschenden Bedingungen in der Bestrahlungseinheit gasförmigen Reaktionsprodukten durch kryotechnische Maßnahmen eine teilweise Kondensation auf den optischen Komponenten erreicht werden, um die Konzentration des Reaktionspartners weiter zu erhöhen.

Eine besonders vorteilhafte Vorrichtung ist derart gestaltet, dass mindestens eine optische Komponente eine in Hinblick für die Strahlen im wesentlichen transparente Beschichtung aus einem Material, wie beispielsweise Platin, Palladium, Gold, Ruthenium, Nickel, $SiO_2$ oder dessen Legierungen aufweist. Die Beschichtung dient als eine Art Deckschicht, die unerwünschte chemische Reaktionen mit dem Spiegelmaterial vermeiden soll und zum Beispiel eine katalytische Funktion bei der chemischen Reaktion zwischen den Ablagerungen mit dem Reaktionspartner übernehmen kann.

Um beispielsweise die Kondensation der metallhaltigen Substanz auf der optischen Komponente zu verringern, ist die Vorrichtung vorteilhafterweise so ausgebildet, dass mindestens eine optische Komponente eine Heizeinrichtung aufweist und/oder die nicht zu reinigenden Komponenten des Vakuumsystems kühlbar sind. Die Heizeinrichtung ermöglicht eine räumlich begrenzt erhöhte Temperatur, insbesondere auf den Oberflächen der optischen Komponenten. Von besonderem Vorteil ist hierbei, dass sich zwangsläufig eine hohe Abdampfrate des dabei gebildeten Reaktionsproduktes einstellt. Zudem stehen hierbei weitere geeignete Reaktionspartner zur Verfügung, da deren Reaktionsprodukte naturgemäß bei erhöhter Oberflächentemperatur einen höheren Dampfdruck aufweisen und somit leichter zu entfernen sind.

Eine Weiterbildung der Erfindung sieht vor, dass die Reinigung während einer Betriebspause durchführbar ist. Dies wird mit Offline-Reinigung bezeichnet.

Vorzugsweise ist die Vorrichtung außerdem derart ausgeführt, dass Temperatur und/oder der Partialdruck des Reinigungspartners einstellbar ist/sind.

Damit während des Reinigungsbetriebs die Anzahl der mit dem Reaktionspartner beaufschlagten Komponenten so gering wie möglich gehalten werden kann, ist es vorteilhaft, wenn die zu reinigenden optischen Komponenten durch bewegbare Abschließer oder durch Bewegen für die Dauer des Reinigungsvorgangs vom übrigen Vakuumsystem abtrennbar sind.

Eine Weiterbildung der Erfindung sieht vor, dass mehrere Einlässe für Reaktionspartner vorhanden sind.

Um nicht beteiligte Komponenten bei der Reinigung noch besser schützen zu können, ist es vorteilhaft, wenn zusätzlich im Bereich dieser Komponenten ein Inertgas und/oder zur Reinigung der optischen Komponenten der Reaktionspartner als ein Reaktionspartner-Inertgas-Gemisch zuführbar ist.

Der Schutz der bei der Reinigung nicht beteiligten Komponenten, aber auch der zu reinigenden Komponenten kann dadurch erhöht werden, wenn die reflektierenden Schichten der optischen Komponenten, die z.B. aus Ruthenium (Ru), Palladium (Pd), Rhodium (Rh), Molybdän (Mo), Silizium (Si) oder Beryllium (Be) bestehen, und die übrigen Untergrundschichten und Halterungen aus chemischen Inertmaterialien, wie zum Beispiel Ruthenium (Ru), Rhodium (Rh), Platin (Pt), Gold (Au), Nickel (Ni) oder Siliziumdioxid (SiO$_2$) oder Kohlenstoff (C) bestehen oder damit überzogen sind.

Um die Menge der von den optischen Komponenten zu entfernenden Ablagerungen von vom herein verringern zu können, ist es vorteilhaft, wenn zwischen der Strahlungsquelle und dem Kollektor eine Folienfalle angeordnet ist.

Dabei ist es besonders vorteilhaft, wenn die Folienfalle beheizbar ist.

Ein vorzeitiges Auswechseln der Folienfalle kann dadurch vermieden werden, dass Debris-Material mittels einer Absaugvorrichtung von der Folien-falle absaugbar sind.

Eine weitere Reinigungsmöglichkeit für die Folienfalle besteht darin, dass Debris-Material von aus porösem, schaumartigem oder dochtartigem Material bestehenden an der Folienfalle angeordneten Strukturen aufgrund Kapillarkräften entfernbar sind.

Um eine gezielte Abfuhr des von der Folienfalle aufgenommenen Debris-Materials sicherzustellen, ist es vorteilhaft, wenn die Folienfalle oder ein Teil der Folienfalle in Rotation versetzbar ist.

Eine definierte Ablagerung des Debris-Materials kann vorteilhafterweise dabei dadurch erzielt werden, dass um den Rand der rotierbaren Folienfalle ein stationärer oder in Rotation versetzbarer Auffänger angeordnet ist.

Eine Weiterbildung der Erfindung sieht dabei vor, dass ein Puffergas über mindestens eine Ausströmdüse in den Raum zwischen dem Kollektor und der Folienfalle oder in den Bereich der Folienfalle selbst zuführbar ist.

Dabei ist es besonders vorteilhaft, wenn über einen weiteren Einlass ein Sperrgas im Bereich der Strahlungsquelle und/oder im Bereich des Kollektors zuführbar ist.

Es ist vorteilhafterweise aber auch dadurch möglich, dass das Sperrgas aus einer vom Puffergas für die Folienfalle unterschiedlichen Gasart besteht.

Die durch die Reinigung zu beseitigende Debris-Menge kann vorteilhafterweise von vornherein dadurch reduziert werden, dass Einrichtungen zur Erzeugung von elektrischen und/ oder magnetischen Feldern vorhanden sind.

Weiterhin ist es vorteilhaft, wenn die Folienfalle während der Reinigung mittels Absperreinrichtungen vom übrigen Vakuumsystem abtrennbar ist.

Gemäß einer besonders bevorzugten Weiterbildung der Erfindung ist es vorgesehen, dass eine elektrische Isolation zwischen der Folienfalle und/oder dem Kollektor gegenüber dem Vakuumgefäß vorhanden ist.

Für den Reinigungsvorgang werden hochpräzise Einstellungen der einzelnen Parameter benötigt. Diese Einstellungen können vorteilhafterweise mit einer elektronischen Steuerung erzielt werden.

Diesbezüglich vorteilhafte Weiterbildungen sind in weiteren Unteransprüchen angegeben. Da deren Merkmale und Vorteile mit denjenigen der entsprechenden Verfahren im wesentlichen übereinstimmen, wird auf deren detaillierte Beschreibung verwiesen.

Weitere Vorteile und Merkmale der Erfindung ergeben sich aus der folgenden Beschreibung mehrerer Ausführungsbeispiele sowie aus den Zeichnungen, auf die nun Bezug genommen wird. Es zeigen:

Fig.1 eine schematische Darstellung einer Vorrichtung zum Bestrahlen von Wafern;
Fig.2 die Seitenansicht einer optischen Komponente während des Betriebs mit einer zweiten erfindungsgemäßen Vorrichtung zum Reinigen einer Oberfläche der optischen Komponente;
Fig.3 schematisch den Aufbau eines Quellenmoduls;
Fig.4 das Prinzip der chemischen Reinigung;
Fig.5 ein Schema für die chemische Online-Reinigung;
Fig.6 ein Schema für die chemische Offline-Reinigung;
Fig.7 eine Querschnittansicht durch eine Vorrichtung mit einem Abschließer am Kollektor-Ausgang;
Fig.8 eine Teilquerschnittsansicht einer Vorrichtung mit einem Abschließer am Kollektor-Eingang und -Ausgang;
Fig.9 eine Darstellung zur Erläuterung des Prinzips des Pumpens durch Kühlflächen;
Fig.10 eine Teilansicht mit einer Folienfalle;
Fig.11 eine Detailansicht mit einer Folienfalle;
Fig.12 eine weitere Teilansicht mit einer doppelten Folienfalle;
Fig.13 eine Detailansicht mit einem Gaspuffer in der EUV-Lampe;
Fig.14 eine Prinzipansicht zur Darstellung der chemischen Reinigung einer Folienfalle;
Fig.15 eine Prinzipansicht zur Darstellung der mechanischen Reinigung einer Folienfalle;
Fig.16 eine Detailansicht mit einer in Rotation versetzbaren Folienfalle;
Fig.17 eine Detailansicht mit in Rotation versetzbarer und stationärer Folienfalle; und
Fig.18 ein Schaubild zur Darstellung der Regelung des Reinigungsvorganges.

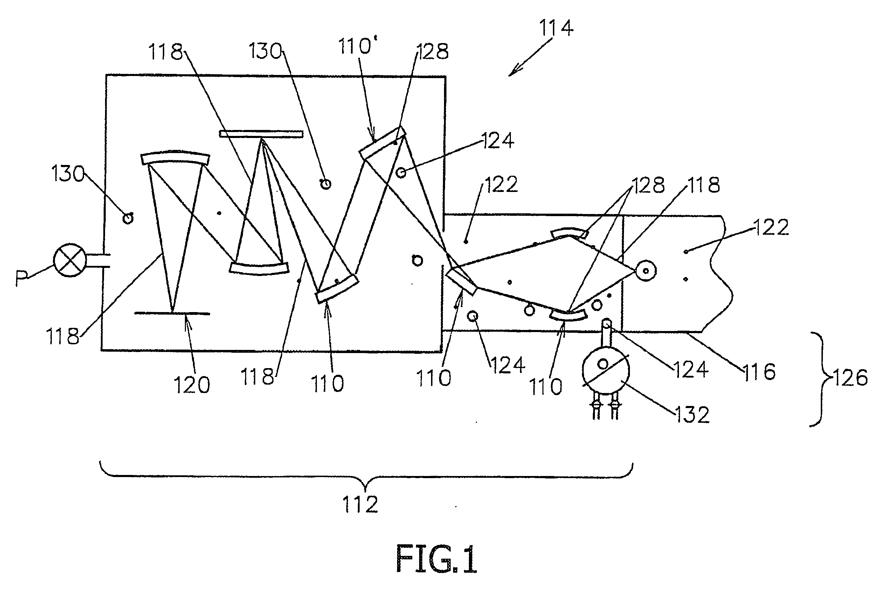

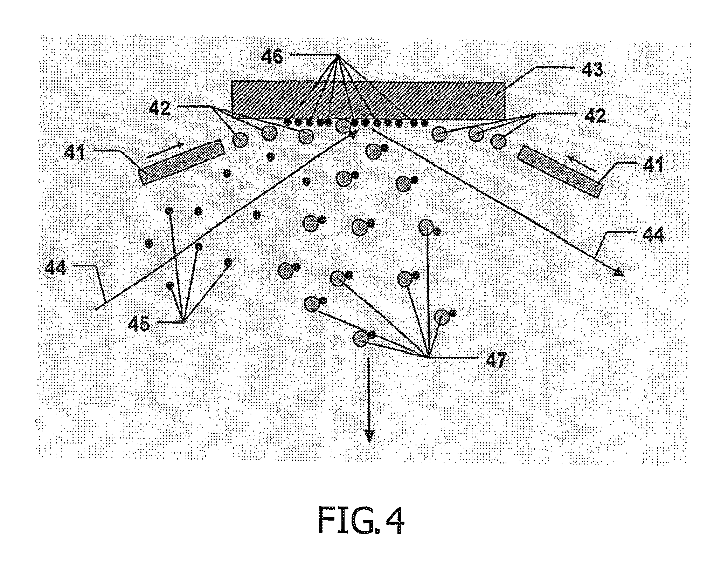

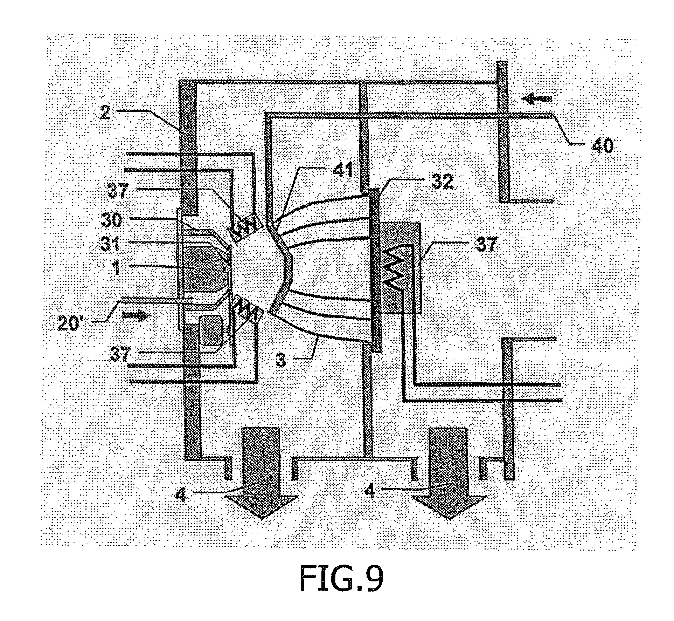

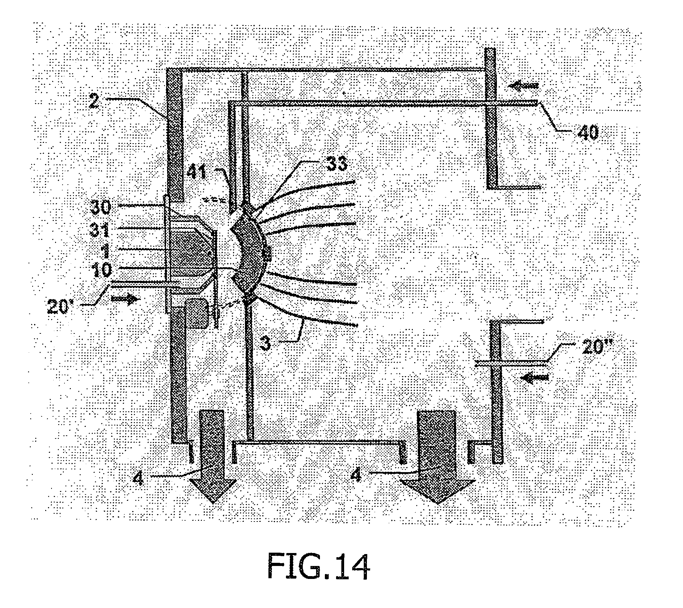

Anhand der Figuren 1 bis 18 werden nun mehrere Ausführungsbeispiele der Erfindung beschrieben. Gleiche Bezugszeichen benennen dabei stets dieselben konstruktiven Merkmale und beziehen sich, soweit im folgenden nichts anderes gesagt ist, stets auf alle Figuren.

Unter Bezugnahme auf Fig.1 wird das erfindungsgemäße Funktionsprinzip einer Vorrichtung zum Reinigen von optischen Komponenten 110 beschrieben, die in einer Bestrahlungseinrichtung 112 so angeordnet sind, dass innerhalb einer Vakuumkammer 114 ausgehend von einer Strahlungsquelle 116 Strahlen 118 auf ein zu bearbeitendes Werkstück 120 geleitet werden. Die Strahlungsquelle 116 stellt hierbei insbesondere extrem-ultraviolette und/oder weiche Röntgenstrahlen bereit, die zum Bestrahlen des Werkstücks 120 beispielsweise eines Wafers dienen. Die Strahlen 118 werden hierbei in der Strahlungsquelle 116 durch ein heißes Plasma erzeugt. Zum Erzeugen dieses Plasmas kann sowohl ein durch elektrische Entladung anregbares Arbeitsgas, wie beispielsweise ein Metalldampf, als auch ein durch Laserstrahlpulse verdampfendes Target verwandt werden. In beiden Fällen werden anorganische Substanzen 122, vorzugsweise eine metallhaltige, insbesondere zinnhaltige Substanz, durch die Strahlungsquelle 116 in die Vakuumkammer 114 eingebracht, die insbesondere die optischen Komponenten 110 verschmutzen.

Durch den hauptsächlich während des Betriebs der Bestrahlungseinrichtung 112 vorzunehmenden Einlass eines vorzugsweise unter den herrschenden Druck- und Temperaturverhältnissen in der Vakuumkammer 114 gasförmigen und/oder flüssigen Reaktionspartners 124 über eine Zuführungseinrichtung 126 wird eine chemische Reaktion beispielsweise mit der anorganischen Substanz 122 bzw. den die optische Komponente 110 verschmutzenden Ablagerungen 128 initiiert. Dabei werden die Ablagerungen 128 in ein flüssiges oder flüchtiges Reaktionsprodukt 130 überführt, welches sich beispielsweise über eine hier links der Bestrahlungseinrichtung 112 angeordnete Vakuumpumpe P aus der Vakuumkammer 114 ausgeschleust werden kann. Der über eine Dosiereinrichtung 132 wahlweise zugeführte Reaktionspartner 124 wird in Abhängigkeit von der anorganischen Substanz 122 so ausgewählt, dass sowohl eine schnelle wie auch selektive Umsetzung erfolgen kann, um eventuell auftretende Nebenreaktionen mit beispielsweise Teilen der Vakuumkammer 114 weitgehend zu vermeiden.

Da insbesondere die hier gezeigten optischen Komponenten 110 im Gegensatz zu den optischen Komponenten 110' relativ nahe an der Strahlungsquelle 116 angeordnet sind, empfiehlt sich eine Zuführung des Reaktionspartners 124 zwischen Strahlungsquelle 116 und optischer Komponente 110, da in diesem Bereich eine höhere Ablagerungsrate der anorganischen Substanz 122 zu erwarten ist.

Als Reaktionspartner 124 kommen insbesondere wasserstoffhaltige Substanzen und/oder Halogene, Interhalogen-, halogenhaltige Verbindungen und/oder eine Kombination daraus in Betracht. Hierbei weist beispielsweise das elementare Chlor eine geringe Absorption bezüglich der EUV-Strahlen auf und bildet in der Vakuumkammer 114 leicht sehr reaktive Chlorradikale. Die bei der chemischen Reaktion gebildeten Chloride weisen hierbei häufig deutlich höhere Dampfdrücke und somit niedrigere Siedepunkte bezüglich des darin enthaltenen anorganischen Kations auf. So siedet beispielsweise elementares Zinn unter Normalbedingungen bei etwa 2687°C, während unter gleichen Bedingungen $SnCl_2$ bei etwa 605°C und $SnCl_4$ bereits bei etwa 114°C sieden. Der Reaktionspartner 124 wird insbesondere während des Betriebs der Strahlungsquelle 116 ständig zugeführt, um eine Kontamination der optischen Komponenten 110 durch den hier beschriebenen Prozess zu entfernen. Diese Zuführung kann dabei sowohl kontinuierlich als auch in Form von Pulsen so gesteuert werden, dass die Zuführung in Abhängigkeit von der vorbestimmten Reaktionskinetik erfolgt. Die Zuführung des Reaktionspartners erfolgt räumlich und zeitlich begrenzt im Überschuss oder bis zur chemischen Äquivalenz bezüglich der durch die Strahlungsquelle 116 eingetragenen Mende an anorganischer Substanz 122 um eine vollständige Umsetzung zu erreichen.

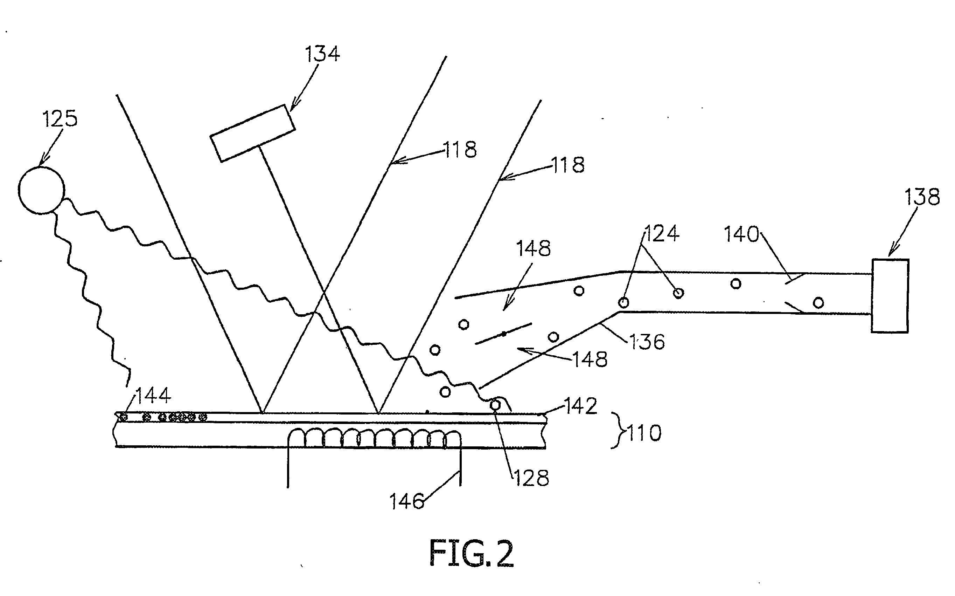

Um die optimale Menge an Reaktionspartner 124 gesteuert zuführen zu können, wird, wie in Fig.2 gezeigt, beispielsweise eine Messeinrichtung 134 verwandt. Diese Messeinrichtung 134 kann beispielsweise die Intensität der Strahlen 118 detektieren, die von der optischen Komponente 110 reflektiert werden. Dies geschieht vorzugsweise immer dann, wenn eine Maske und/ oder ein Wafer 120 während des lithographischen Prozesses gewechselt werden muss.

Durch die hier gezeigte Zuleitung 136 kann der zuzuführende Reaktionspartner 124 räumlich begrenzt in hoher Konzentration auf eine reflektierende Oberfläche der optischen Komponente 110 fokussiert werden. Hierdurch kann eine höhere Reaktionsrate zwischen den Ablagerungen 128 und dem Reaktionspartner 124 erreicht werden.

Die Konzentration des Reaktionspartners 124 kann zusätzlich dadurch gesteigert werden, dass insbesondere gasförmige Reaktionspartner 124 durch eine zusätzliche Kühlung 138 bzw. unter Verwendung von kryotechnischen Maßnahmen, wie dem Joule-Thompson-Effekt durch eine Düse 140 zumindest zeitweise verflüssigt werden, um die verschmutzte Oberfläche zeitlich begrenzt zu benetzen.

Durch eine hier gezeigte zusätzliche Anregungseinrichtung 125 kann zudem der Reaktionspartner 124 durch beispielsweise Bestrahlung mit energiereichem Licht in chemisch besonders reaktive Radikale umgewandelt werden, um die Reaktionsrate weiter zu steigern.

Nebenreaktionen durch das Benetzen mit Reaktionspartner 124 auf der Oberfläche der optischen Komponente 110 können durch eine zusätzliche in Hinblick für die Strahlen im wesentlichen transparente Beschichtung 142 weiter vermindert werden. Diese enthält ein Material 144, das beispielsweise die Übergangsmetalle Platin, Palladium, Ruthenium, Rhodium, Gold oder deren Legierungen und Verbindungen, z.B. Oxide oder Nitride, oder auch Siliziumdioxid oder Kohlenstoff umfasst. Diese können die gezielte Umsetzung der Ablagerungen 128 mit dem Reaktionspartner 124 beispielsweise katalytisch unterstützen. Es sind aber auch noch andere Beschichtungsmaterialien möglich, die weiter unten beschrieben werden.

Durch eine Heizeinrichtung 146, die wie hier gezeigt beispielsweise in die optische Komponente 110 integriert ist wird eine Temperatur, zum Beispiel durch Ohm'sche Heizung, von etwa 20°C bis 800°C, vorzugsweise 400°C erreicht. Eine Temperaturerhöhung führt bekanntlich in den allermeisten hier zu berücksichtigenden Fällen zu einer höheren Abdampfrate. Da eine Kontamination der Oberfläche der optischen Komponente 110 durch die Ablagerungen 128 je nach ihrer Anordnung in der Bestrahlungseinrichtung 112, wie in Fig. 1 gezeigt, variiert, kann die Konzentration des Reaktionspartners 24 durch Aufteilung in Sektoren 148 innerhalb der Zuleitung 136 bedarfsgerecht angepasst werden.

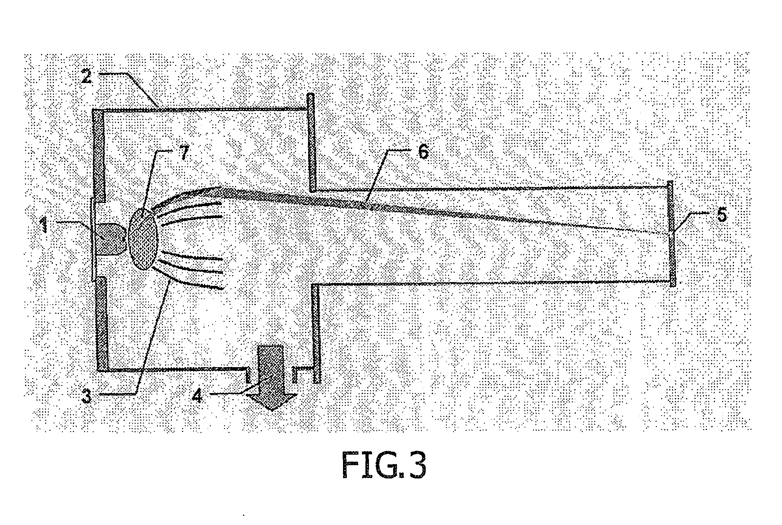

Mit Bezug auf die Figuren 3 bis 18 werden nunmehr weitere Ausführungsbeispiele der Erfindung beschrieben. Auf der optischen Komponente 43, z.B. einem Spiegel, die EUV-Strahlung 44 oder EUV-Licht aus einer Strahlungsquelle 1 reflektiert, bilden die bei Betrieb der Quelle oder Lampe 1 emittierten Debris-Partikel 45 eine unerwünschte Ablagerung oder deponierte Debris-Partikel 46. Durch selektive chemische Reaktionen auf der Oberfläche der optischen Komponente 43 mit einem mittels eines lokalen Einlasses oder Ausströmdüsen 41 zugeführten Reaktionspartners oder Reinigungsgas 42 werden die kondensierten Ablagerungen 46 in flüchtige Substanzen oder Reaktionsprodukte 47 überführt. Diese verdampfen und können durch Pumpen entfernt werden. Dazu werden die zugegebenen Reaktionspartner so gewählt, dass sie mit den kondensierten Metallen Verbindungen bilden, deren Dampfdrücke bei der Temperatur der optischen Komponente 43, über den umgebenden Partialdrücken der Metallverbindungen liegen.

Die Auswahl der chemischen Reaktionspartner 42 richtet sich zunächst nach der Reaktion mit dem deponierten Metall. Eine möglichst schnelle Reaktion muss zu einem flüchtigen Produkt führen. Ein weiteres Kriterium ist eine gute optische Transmission des Reaktionspartners 42 im EUV-Bereich, so dass durch die Anwesenheit des chemischen Reaktionspartners 42 die EUV-Intensität nicht nennenswert geschwächt wird. Schließlich soll die Reaktion selektiv erfolgen, d.h. der Reaktionspartner 42 soll effektiv mit der kondensierten Verunreinigung oder Ablagerung 46 reagieren, während eine Reaktion mit den Materialien der optischen Komponente 43 möglichst gering sein soll.

Als Reaktionspartner 42 geeignet sind Halogene wie $Cl_2$, $Br_2$, $F_2$, $J_2$, deren atomaren Radikale sowie Verbindungen, die diese Halogene enthalten. Sie führen zur Bildung von flüchtigen Metallhalogeniden. Geeignet sind auch Wasserstoff und wasserstoffhaltige Verbindungen. Für die Selektivität müssen die Reaktionsbedingungen, wie Temperatur und Konzentration des zugeführten Reaktionspartners 42, so gewählt werden, dass die Verbindung mit der Verunreinigung wie z. B. Zinnchlorid viel schneller gebildet wird, als eine Verbindung mit einem Spiegelmaterial wie z. B. Rutheniumchlorid. Auf diese Weise können die Bedingungen so gesteuert werden, dass die Verunreinigung entfernt ist, bevor es zu einem nennenswerten Angriff des Spiegelmaterials kommt.

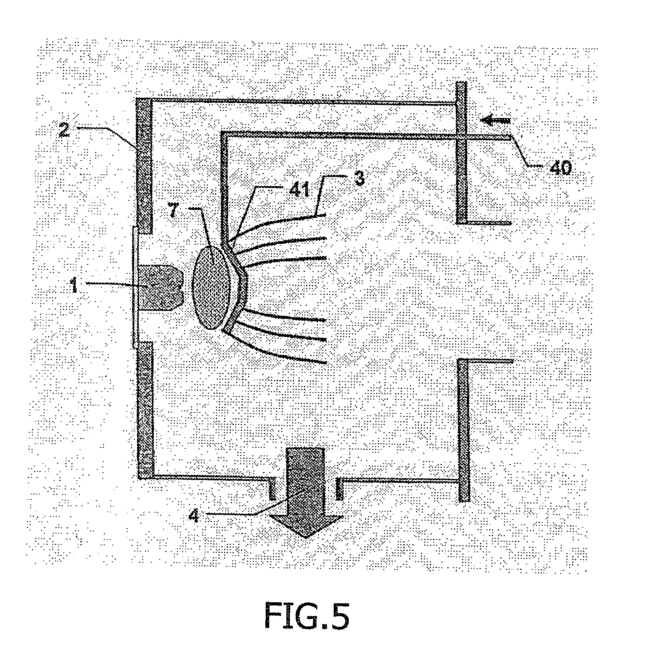

Die Reinigung kann während des Betriebs der EUV Apparatur erfolgen, eine sogenannte Online-Reinigung, die in Fig. 5 gezeigt ist. Ziel ist hierbei, bei einer bestimmten Temperatur der optischen Komponente 43 lokal so viel Halogen oder Wasserstoff einzuleiten, dass gerade die Menge des deponierten Materials der Menge des reagierenden und verdampfenden Materials entspricht. Die Reflektivität der optischen Komponente 43 bleibt dann konstant. Die Anwesenheit der EUV Strahlung 44 führt zur Bildung von Halogen- oder Wasserstoffradikalen, wodurch die Reaktivität gesteigert wird. Andererseits können gebildete flüchtige Metallverbindungen teilweise auch wieder dissoziieren und rekondensieren, was die Geschwindigkeit des Nettoabtrages reduziert. Diese strahlungsbedingten Veränderungen in der Abtragsgeschwindigkeit können aber durch die Gasdosierung kompensiert werden. Bei dieser Form der Reinigung werden Gaseinlass, zum Beispiel die Reinigungsgas-Zufuhr 40 oder die Ausströmdüsen 41, und Pumpanordnung so gestaltet, dass die Partialdrücke von halogenhaltigen und wasserstoffhaltigen Substanzen jeweils nur am Ort der gewünschten Reinigung erhöht und sonst ausreichend gering sind, um den Betrieb der Belichtungseinheit nicht zu stören und die Lebensdauer anderer Komponenten nicht zu beeinflussen.

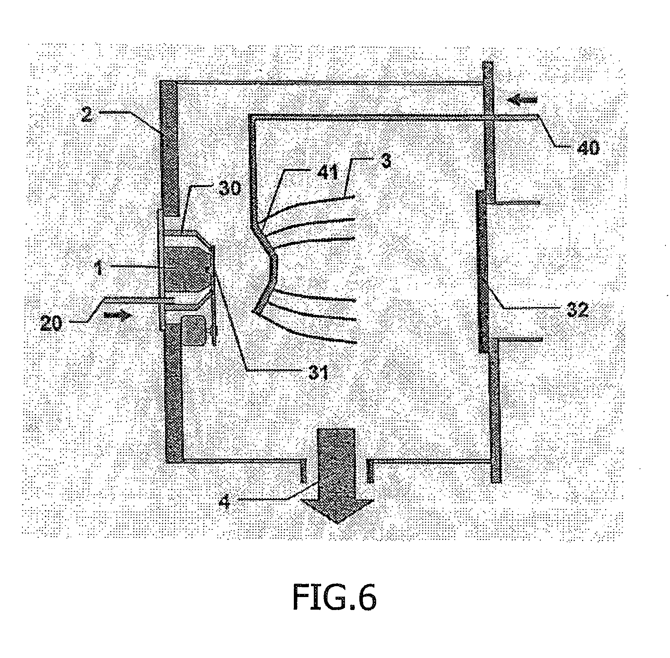

Die Reinigung kann auch in Betriebspausen erfolgen, eine sogenannte Offline-Reinigung, siehe Fig.6, wobei die verschmutzten optischen Komponenten 43 in der Apparatur verbleiben, so dass keine Demontage mit entsprechend langen Ausfallzeiten nötig ist. Vielmehr können die Reinigungszyklen durch entsprechende Wahl der Parameter sehr kurz gestaltet werden.

Zu diesem Zweck können die zu reinigenden optischen Komponenten wie z.B. die Kollektoroptik oder der Kollektor 3 durch bewegliche Abschließer, oder Lampengehäuse 30, Lampenabschließer 31 ein kollektorseitiger Abschließer 32, bzw. Ventile für die Dauer des Reinigungsvorgangs vom übrigen Vakuumsystem getrennt werden. Durch Wahl von Temperatur und Partialdruck des Reaktionsgases kann der Reinigungszyklus bezüglich Geschwindigkeit optimiert werden, ohne dass auf die Komponenten in dem übrigen Vakuumsystem Rücksicht genommen werden muss. Nach Abpumpen der Reaktionsprodukte aus dem abgeschlossenen Reinigungsbereich werden die Abschließer 30,31,32 wieder geöffnet und der Betrieb der Belichtungseinheit kann fortgesetzt werden.

Der Einlass des Reaktionsgases oder Reinigungsgases 42 erfolgt vorzugsweise in der Nähe der zu reinigenden optischen Komponente 43 und ist auf diese gerichtet. Idealerweise stellt die zu reinigende Oberfläche die erste Wand dar, auf die das Reaktionsgas 42 nach Austritt aus der Zuleitung auftrifft. Durch mehrere lokale Gaseinlässe können verschiedene Bereiche der optischen Komponente 43 unterschiedlich starken Partialdrücken des Reaktionsgases ausgesetzt werden, wenn unterschiedlich starke Verunreinigung vorliegt. Das an der zu reinigenden Oberfläche der optischen Komponente 43 gebildete flüchtige Reaktionsprodukt und eventuell überschüssiges Reaktionsgas 42 wird abgepumpt.

Durch Zugabe von Inertgas in Bereiche des Vakuumsystems, die nicht mit dem Reinigungsgas 42 behandelt werden sollen, oder auch durch Zugabe des Reaktionsgases als Gemisch mit einem Inertgas, kann die mittlere freie Weglänge zwischen Gasstößen reduziert und dadurch die Diffusion von Reaktionsgas oder auch von Reaktionsprodukten in andere Bereiche des Vakuumsystems verhindert oder zumindest verlangsamt werden. In Kombination mit einem effektiven Pumpsystem kann so der Großteil des Reaktionsproduktes und des überschüssigen Reaktionsgases 42 abgepumpt werden, bevor es zu anderen Komponenten des Vakuumsystems gelangt.

Bei der Offline-Reinigung in Betriebspausen wird die zu reinigende optische Komponente 43 bevorzugt durch Abschließer 30,31,32 vom übrigen Vakuumsystem getrennt. Das Reaktionsgas 42 gelangt so nur in einen abgeschlossenen Bereich. Der abgeschlossene Bereich kann sehr effektiv abgepumpt werden, um nach erfolgter Reinigung schnell wieder die geforderte Gasphasenzusammensetzung zu erreichen. Danach können die Abschließer 30,31,32 bzw. Ventile wieder geöffnet und der Betrieb der Belichtungsanlage fortgesetzt werden.

Wie in Fig.6 dargestellt, ist es z.B. möglich, das Quellenmodul ausgangsseitig durch ein geeignetes Plattenventil bzw. Abschließer 32 abzuschließen. Die Strahlungsquelle 1 kann durch ein Lampengehäuse 30 und einen beweglichen Abschließer 31 abgeschirmt werden. Hier ist vorgesehen, das Eindringen des reaktiven Reinigungsgases 42 zusätzlich durch Zufuhr eines Inertgases oder Puffergases 20 zu verhindern.

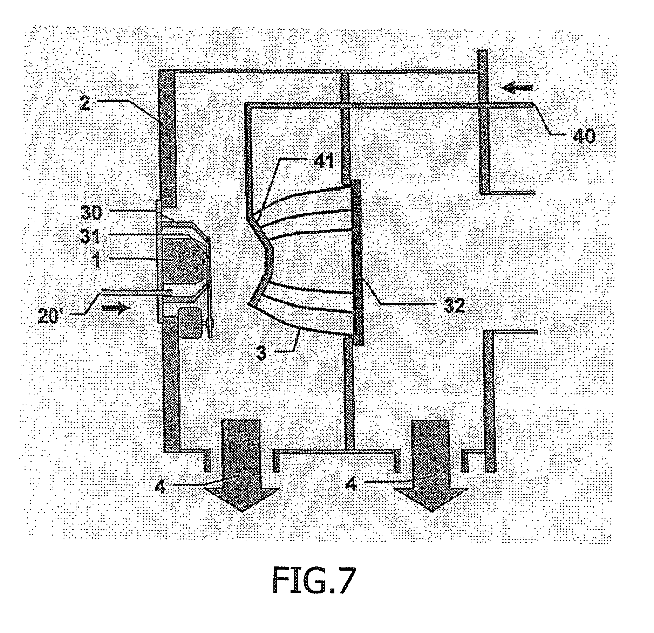

Für die Offline-Reinigung können verschiedene weitere Ausführungsformen der Anordnung und Abtrennung des Reinigungsvolumens verwendet werden. In Fig.7 wird der ausgangsseitige Abschließer 32 unmittelbar am Ausgang des Kollektors 3 angeordnet. Zusätzlich wurde eine Trennung in zwei Pumpräume eingangs- und ausgangsseitig vom Kollektor 3 vorgesehen. Hierdurch wird das mit dem Reinigungsgas 42 in Kontakt kommende Volumen (bzw. Oberfläche) deutlich verkleinert.

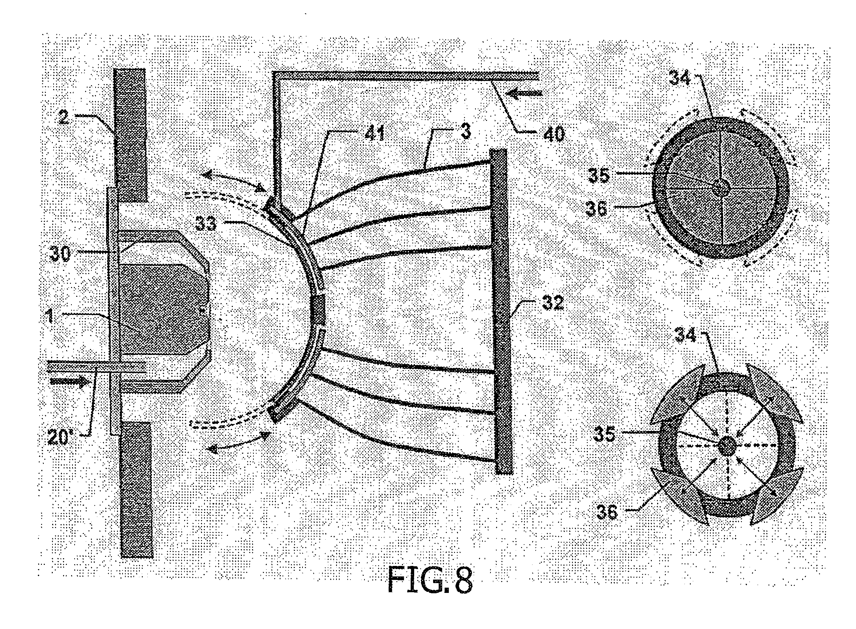

Eine weiter Minimierung des Reinigungsvolumens lässt sich gemäß Fig.8 durch einen Abschließer 33 am Kollektor-Eingang erreichen. Hier ist vorgesehen, dass der Abschließer 33 aus mehreren Segmenten 33c besteht, die beim Betrieb der Quelle 1 zur Seite gefahren werden und so den optischen Strahlengang 6 vollständig freigeben. Diese Bauform ist sehr platzsparend und dient auch bei Vorhandensein eines Debris-Unterdrückungssystems - wie etwa einer Folienfalle 10 - einem Abschluss des Kollektorraums.

Das abgeschlossene Volumen wird entweder durch Leitungen großen Querschnitts mit leistungsfähigen Pumpen verbunden, oder die Verschlusswände um die zu reinigende optische Komponente 43 stellen selbst eine effektive Pumpe dar. Dies ist durch die Integration von gekühlten Flächen in die Verschlusswände möglich, die kalt genug sind, so dass sowohl Reaktionsprodukt als auch überschüssiges Reaktionsgas 42 nahezu vollständig auskondensieren. Die Kühlflächen mit den auskondensierten Substanzen werden nach der Reinigung durch Vakuumschleusen in andere Vakuumbehälter überführt, wo sie dann erwärmt und die abdampfenden Substanzen abgepumpt werden können. Die Sorption durch Kühlflächen kann bei Bedarf durch geeignete Beschichtung mit einer effektiveren chemischen Sorption (z.B. mittels Aktivkohle) kombiniert werden, wie es in der Vakuumtechnik bekannt ist.

Bei der Online-Reinigung während des Betriebes erfolgt der lokal regulierte Gaseinlass permanent, und Reaktionsprodukte und überschüssiges Reaktionsgas müssen kontinuierlich abgepumpt werden. Hohe Pumpleistungen in Nähe der zu reinigenden optischen Komponenten 43 können wieder durch große Pumpquerschnitte und/oder lokale thermische oder thermisch-chemische Sorption realisiert werden. Für den kontinuierlichen Betrieb müssen die Sorptionsflächen jeweils von Zeit zu Zeit im Wechsel hinter Vakuumschleusen regeneriert werden.

Bereiche, in die Reaktionsprodukte oder überschüssige Reaktionsgase 42 nicht gelangen dürfen, wie die EUV Lichtquelle 1, die Folienfalle 10, optische Komponenten 43, die gegenüber den verwendeten Reinigungsgasen 42 nicht beständig sind, der jenseits des Zwischenfokus liegende Masken- und Waferbereich, können durch differentielle Pumpstufen und gezielte Gegenflüsse mit EUV-transparentem Inertgas geschützt werden. Hierbei sind vor allem Edelgase wie zum Beispiel Helium sehr günstig, da es inert und relativ transparent für EUV Licht ist. Darüber hinaus kann man die lokalen Sorptionsflächen so auslegen, dass sie z.B. Helium nicht pumpen und dadurch weniger schnell belegt werden und regeneriert werden müssen. Auch andere Gase sind in gleicher Weise möglich, z.B. Wasserstoff und Stickstoff.

Die chemische Reinigung erfolgt selektiv, so dass die Metallverunreinigungen entfernt werden, ohne dass die optische Komponente 43 mit dem eingelassenen Reinigungsgas 42 reagiert. Dies wird durch eine geeignete Wahl von Reaktionsgas 42 und Reaktionsbedingungen wie Temperatur und Partialdruck des Reaktionsgases erreicht. Der verfügbare Parameterraum wird durch eine geeignete Materialauswahl bei den optischen Komponenten 43 vergrößert. Während die Wahl der EUV reflektierenden Schichten durch die hohen Reflektionsanforderungen bei Spiegeln für streifende Reflexion auf Materialien wie Ru und Pd und bei Spiegeln für senkrechte Reflexion auf Mo, Si und Be beschränkt ist, ergibt sich für die Untergrundschichten und die Halterungen mehr Freiheit. Hier kann auf chemisch inerte Materialien wie zum Beispiel Ru, Pt, Au, Ni oder $SiO_2$ zurückgegriffen werden.

Hierbei genügt es, die Bauteile der optischen Komponente 43 mit einer dünnen Schicht eines chemisch inerten Materials wie z. B. Ru, Rh, Pt, Au, Ni oder deren Legierungen oder Verbindungen wie z.B. Oxiden oder Nitriden, aber auch $SiO_2$ oder C zu überziehen und so die Komponenten vor Reaktionen zu schützen. Handelt es sich um den Schutz der reflektierenden oberen Schicht, so wird die Schicht des inerten Materials so dünn gewählt, dass sie die optischen Eigenschaften nur geringfügig verändert.

Durch die Temperatur der optischen Komponente wird die Reaktionsgeschwindigkeit der kondensierten Metalle und die Abdampfgeschwindigkeit der Reaktionsprodukte gesteuert. Andererseits beeinflusst sie auch mögliche Reaktionen zwischen dem Material der optischen Komponente 43 und den zugegebenen Reaktionsgasen 42, so dass über die Temperatur die Selektivität der Reaktion beeinflusst wird.

Durch gezieltes Heizen der Komponenten wird die Reinigung mittels selektiver chemischer Reaktionen verstärkt. Die Geschwindigkeit, mit der die Metallverbindungen in heterogenen Oberflächenreaktionen gebildet werden, steigt mit der Temperatur der Oberfläche. Der Dampfdruck der gebildeten Metallverbindungen steigt ebenfalls mit der Temperatur. Da das Kriterium für ein Abdampfen darin besteht, dass der Dampfdruck der Verbindung größer ist als der Partialdruck der Verbindung in der Umgebung, erfüllt bei höherer Temperatur eine größere Anzahl von Verbindungen dieses Kriterium. Außerdem wird die Abdampfgeschwindigkeit von dem Dampfdruck über der Fläche und der thermischen Geschwindigkeit bestimmt. Da beide mit zunehmender Temperatur steigen, führt eine höhere Temperatur zu einer schnelleren Abdampfrate.

Mögliche ungewollte Reaktionen mit dem Kollektormaterial gewinnen mit zunehmender Temperatur aber ebenfalls an Bedeutung, da auch hier Reaktionsgeschwindigkeit und auch die Flüchtigkeit der Produkte mit der Temperatur zunimmt.

So ist es im Sinne der Erfindung erstrebenswert, die Temperatur der optischen Komponenten 43 mittels Heizungen oder Kühlvorrichtungen so zu wählen, dass eine ausreichende Abtragsrate für Metallverunreinigungen bei einem vernachlässigbaren Angriff der optisch relevanten Oberflächen erreicht wird.

Temperatureinschränkend sind auch die Materialeigenschaften der optischen Komponenten 43, die Temperaturverträglichkeit des Gesamtsystems und die Temperaturabhängigkeit der chemischen Reaktionsgleichgewichts. Bei zu hohen Temperaturen neigt sich das Reaktionsgleichgewicht von der Metallverbindung weg hin zu den Ausgangsprodukten.

Bei der Offline-Reinigung in Betriebspausen sind Vakuumbehälter oder sonst im Vakuum befindliche Bauteile gegenüber den Reaktionsgasen 42 und Reaktionsprodukten geschützt. Bei der Online-Reinigung im Betrieb können auch nicht zu reinigende Komponenten mit den Reaktionsgasen und den Reaktionsprodukten in Berührung kommen. Dies könnte zu einem chemischen Angriff der Oberflächen führen und bei der Bildung flüchtiger Produkte zur Freisetzung unerwünschter Substanzen in die Gasphase führen.

Um dies zu verhindern, werden Gaseinlass und Pumpschema so gestaltet, dass die Partialdrücke der Reaktionsgase nur an den zu reinigenden Komponenten erhöht sind. Darüber hinaus werden der Vakuumbehälter selbst und sonstige Bauteile dadurch geschützt, dass sie auf Temperaturen gehalten werden, die unter den Temperaturen der zu reinigenden Komponenten liegen. Hierzu werden geeignete Kühlvorrichtungen vorgesehen. Niedrige Temperaturen reduzieren die Reaktivität stark, so dass der durch die niedrigeren Partialdrücke schon reduzierte chemische Stoffmengenumsatz noch weiter verringert wird. Niedrige Temperaturen führen außerdem zu geringen Dampfdrücken der Reaktionsprodukte, so dass nur sehr wenig in die Gasphase gelangt.

Reichen eine Reduktion der Temperatur und des Partialdruckes des Reaktionsgases allein nicht aus, so können weitere Maßnahmen ergriffen werden, um die Komponenten zu schützen. Idealerweise werden die Komponenten aus chemisch inerten Materialien gefertigt oder zumindest mit diesen beschichtet. Möglich ist auch die Wahl reaktiver Materialien, deren Reaktionsprodukte aber bei den vorliegenden Temperaturen nicht flüchtig sind, so dass die Reaktionsprodukte an der Oberfläche verbleiben und diese somit chemisch passivieren.

Schließlich können auch durch die lokale Zugabe zusätzlicher Reaktionsgase Flächen passiviert werden oder flüchtige in nicht flüchtige Substanzen überführt werden. Durch die Zugabe von Sauerstoff können vorhandene oder deponierte Metalle in Metalloxide überführt werden. Diese sind meist chemisch stabiler als Metallhalogenide, so dass dadurch eine weitere Bildung von Metallhalogeniden durch Reaktion mit dem Reinigungsgas 42 verhindert wird. Außerdem sind die gebildeten Metalloxide meist schwerflüchtig, so dass sie als passivierende Oberflächenschicht zurückbleiben und die Gasphase nicht beeinträchtigen.

Kondensieren an den kälteren Komponenten flüchtige Reaktionsprodukte aus der Reinigung der wärmeren optischen Komponenten, wie z.B. Metallhalogenide, werden diese auf Grund der niedrigeren Temperaturen langsam verdampfen und die Gasphase je nach temperaturabhängigem Dampfdruck langzeitig verunreinigen. Dies kann durch Zugabe von Sauerstoff verhindert werden, wobei schwerflüchtige Metalloxide gebildet werden, die nicht in die Gasphase übergehen und die Oberfläche passivieren. Das freigesetzte, auch bei niedrigen Temperaturen leicht flüchtige Halogen kann dann schnell abgepumpt werden.

Auch Wasserstoff kann als zusätzliches Reaktionsgas zugegeben werden. Der in der chemischen Reaktion entstehende, leichtflüchtige Halogenwasserstoff wird schnell abgepumpt, während das schwerflüchtige reine Metall zurückbleibt. Im Gegensatz zur Sauerstoffzugabe fehlt hier jedoch die Passivierung, da das reine Metall im Gegensatz zum Oxid, wieder mit einem Halogen zu einem Metallhalogenid reagieren kann.

Wie zuvor beschrieben, kann beim Betrieb eines Quellensystems mit metallischen Arbeitsmedien der Kollektor 3 mit Hilfe der chemischen Reinigung von metallischen Ablagerungen frei gehalten werden. Es kann ein wirtschaftlich effizienterer Langzeitbetrieb dann erreicht werden, wenn in das System eine Einrichtung zur Debris-Unterdrückung zwischen Strahlungsquelle 1 und Kollektor 3 integriert wird.

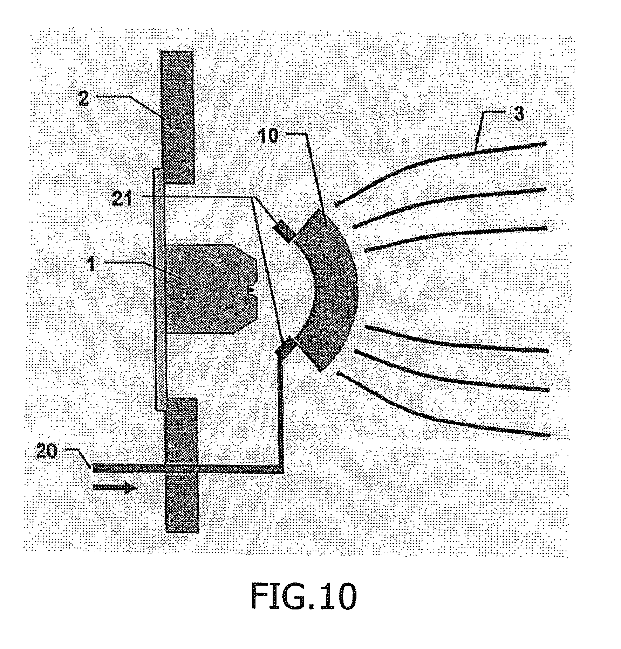

Ein sehr effektives System zur Debris-Unterdrückung ist die schon erwähnte Folienfalle 10. Eine typische Anordnung einer Folienfalle 10 ist in Fig.10 dargestellt. Hauptbestandteile der Folienfalle 10 sind: a) eine Vielzahl von dünnen Folien bzw. Lamellen, die so angeordnet sind, dass das von der Strahlungsquelle 1 emittierte Licht minimal blockiert wird, sich andererseits enge Kanäle ergeben, die schräg zu den Lamellen fliegende Partikel auffangen und mindestens kurzzeitig absorbieren, und b) ein Puffergas 20, durch eine Gaszufuhr 21 zugeführt wird, das einfallende Debris-Partikel durch Gasstöße aus ihrer Flugbahn ablenkt und damit den ungestörten Flug durch die Kanäle zwischen den Lamellen verhindert.

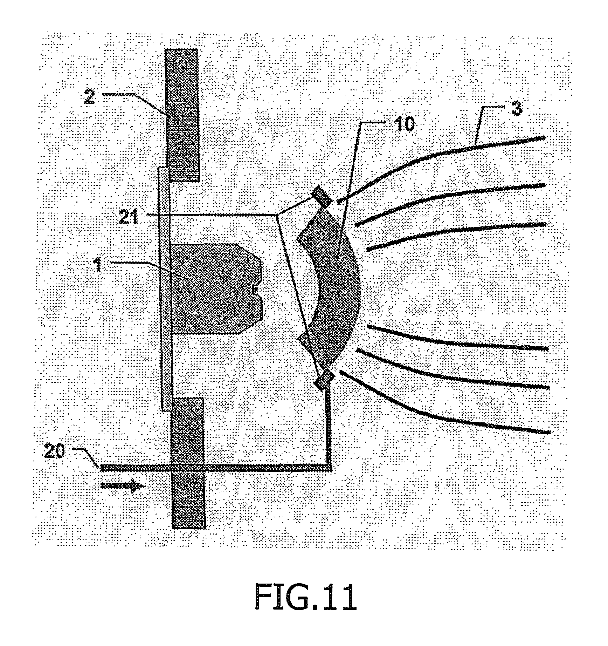

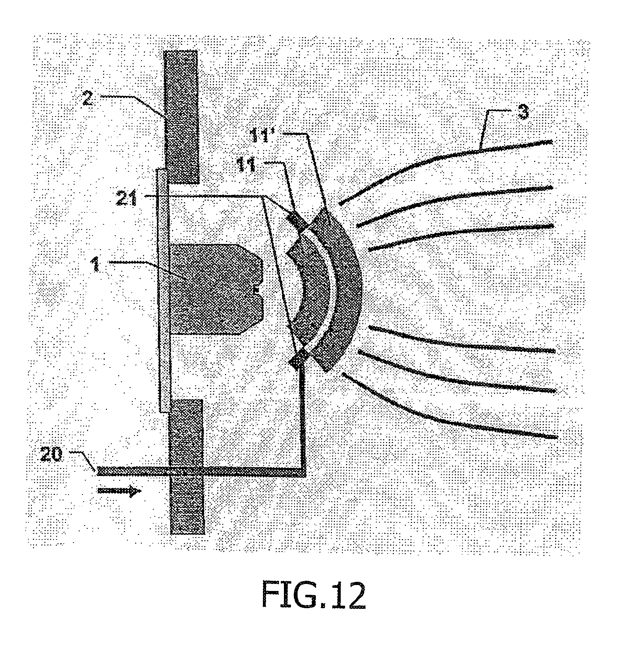

Andere Ausführungsformen einer Folienfalle sind in den Fig.11 und 12 dargestellt. Bei Fig.11 erfolgt die Zufuhr des Puffergases 20 vom Kollektor 3 her. Dies ist von Vorteil, wenn der Partialdruck des Puffergases am Ort der Strahlungsquelle 1 nicht zu hoch sein darf. Bei Fig.12 wurde im Vergleich zur Druckverteilung der Fig.10 und 11 eine Zwischenlösung mit einer zweiteiligen Folienfalle 10 dargestellt.

Insbesondere bei Strahlungsquellen 1, die bei Normalbedingungen feste oder flüssige Arbeitsmedien verwenden - etwa Metalle oder Metallsalzlösungen - tritt hierbei jedoch das Problem auf, dass in den engen Kanälen der Folienfalle Ablagerungen des Arbeitsmediums auftreten die nach kurzer Zeit zu einer Verstopfung und damit zu einem Verlust an EUV-Strahlung 44 führen.

Die Menge der Ablagerungen in der Folienfalle 10 beträgt hierbei ein Vielfaches der auf dem Kollektor 3 deponierten Menge. Je effektiver die Folienfalle 10 - wie beabsichtigt - unerwünschte Partikel unterdrückt, d.h. auf ihrer Oberfläche bindet, desto höher ist die Menge der Ablagerungen relativ zur Deposition am Kollektor 3.

Dieses Problem wird auf verschiedene Arten gelöst.

Als eine Lösung wird vorgeschlagen, die Folienfalle 10 analog zu den oben für den Kollektor 3 beschriebenen Methoden chemisch zu regenerieren. Da von der Folienfalle 10 im Vergleich zum Kollektor 3 viel größere Mengen an Ablagerungen zu entfernen sind, sind höhere Dosen des Reinigungsgases 42, d.h. Druck und/oder Einwirkungszeit anzuwenden oder der Reinigungsprozess muss bei höherer Temperatur stattfinden.

Im Detail werden folgende Ausführungsformen der chemischen Reinigung einer Folienfalle 10 vorgeschlagen:

1. Reinigung durch Einlassen einer erhöhten Dosis des Reinigungsmediums 42 in das gesamte Vakuumgefäß. Dies ist möglich wenn alle Strukturmaterialien des Quellenmoduls - insbesondere der Kollektor - resistent gegenüber der erhöhten Reinigungsdosis ist. Der Prozess kann als Online-Reinigung während des Betriebs der Quelle oder als Offline-Reinigung erfolgen.

2. Der Prozess kann unter Durchfluss des Reinigungsmediums 42 dynamisch oder bei völligem Abschluss des Systems statisch durchgeführt werden

3. wie 1 und 2, mit zusätzlicher Heizung der Folienfalle, z.B. elektrisch oder durch Infrarot-Strahlung. Dadurch ist die Reinigung der Folienfalle 10 bei deutlich geringeren Dosen des Reinigungsmediums 42 möglich.

4. Einlass des Reinigungsmediums 42 in ein Teilvolumen des Vakuumgefäßes, das die Folienfalle 10, nicht aber den Kollektor 3 enthält, wahlweise in Kombination mit 2.

5. Anordnung gemäß 3., wobei die Trennung zwischen Folienfalle 10 und Kollektor 3 durch einen mechanischen Abschließer 33 zwischen Folienfalle 10 und Kollektor 3 erreicht wird.

6. Anordnung gemäß 3., wobei die Trennung zwischen Folienfalle 10 und Kollektor 3 durch zwei mechanische Abschließer an Eingang und Ausgang der Folienfalle erreicht wird.

7. Anordnung gemäß 3., wobei durch einen zusätzlichen Abschließer 30,31 die Strahlungsquelle 1 von der chemischen Reinigung ausgeschlossen wird.

8. Anordnung gemäß 3., wobei die Trennung zwischen Folienfalle 10 und Kollektor 3 durch mechanische Verschiebung der Folienfalle 10 in eine vom Haupt-Vakuumgefäß getrennte Reinigungskammer erreicht wird. Durchführung der Reinigung dort analog zu 2. und/oder 3., Rückverschiebung an die Arbeitsposition.

Eine andere Möglichkeit zur Reinigung der Folienfalle 10 kann angewandt werden, wenn beim Betrieb der Quelle 1 das aufgefangene Debris-Material 45 auf den heißen Lamellen der Folienfalle 10 in flüssiger Form vorliegt. Dies ist z.B. bei Verwendung von Zinn als Arbeitsmedium in der Strahlungsquelle 1 gegeben.

Das flüssige Arbeitsmedium wird durch die Schwerkraft entweder zur Symmetrieachse oder zum unteren Rand der Folienfalle fließen. Hier wird es durch eine Absaugung entfernt.

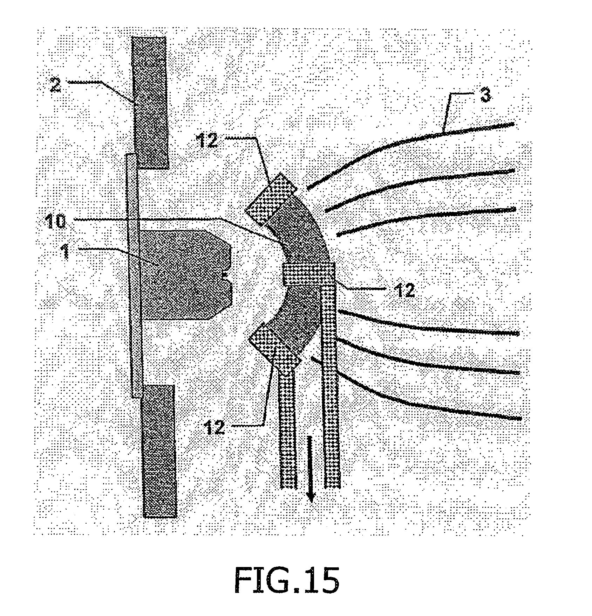

Im Detail werden, wie z.B. aus Fig.15 ersichtlich, folgende Ausführungsformen vorgeschlagen:

1. Aktive Absaugung durch eine Pumpe oder Absaugvorrichtung 12,

2. Abfuhr durch Kapillarkräfte. Es können poröse, schwammartige oder dochtartige Strukturen verwendet werden, die das Material aufnehmen und von der Folienfalle 10 abtransportieren,

3. Anordnung der Vorrichtungen nach 1., 2. auf der Systemachse (optischen Achse),

4. Anordnung der Vorrichtungen nach 1., 2. am Rand der Folienfalle 10,

5. Anordnung der Vorrichtungen nach 1., 2. an Stellen der Folienfalle, die mit Bereichen im optischen Strahlengang korrespondieren, die durch weitere Systemkomponenten abgeschattet sind. Dadurch wird kein zusätzlicher Lichtverlust durch die Absaugeinrichtung selbst hervorgerufen.

Eine weitere Möglichkeit zur Reinigung der Folienfalle 10 kann ebenfalls angewandt werden, wenn beim Betrieb der Quelle 1 das aufgefangene Debris-Material 45 auf den (heißen) Lamellen der Folienfalle 10 in flüssiger Form vorliegt. Dies ist z.B. bei Verwendung von Zinn als Arbeitsmedium in der Strahlungsquelle 1 gegeben.

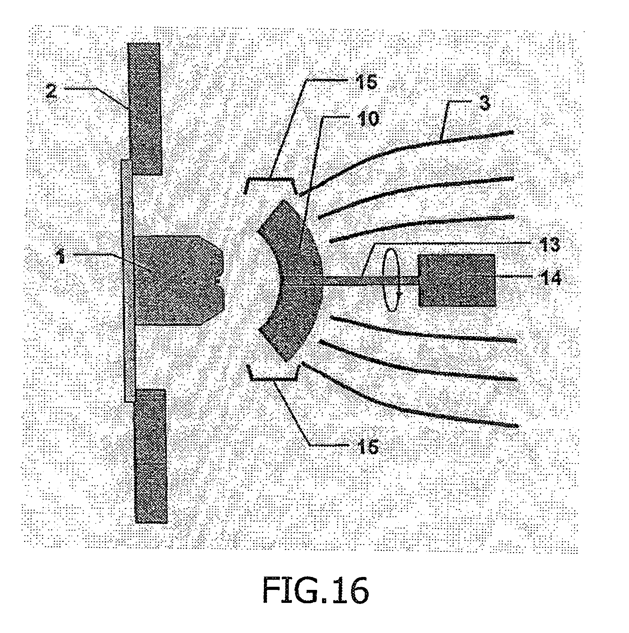

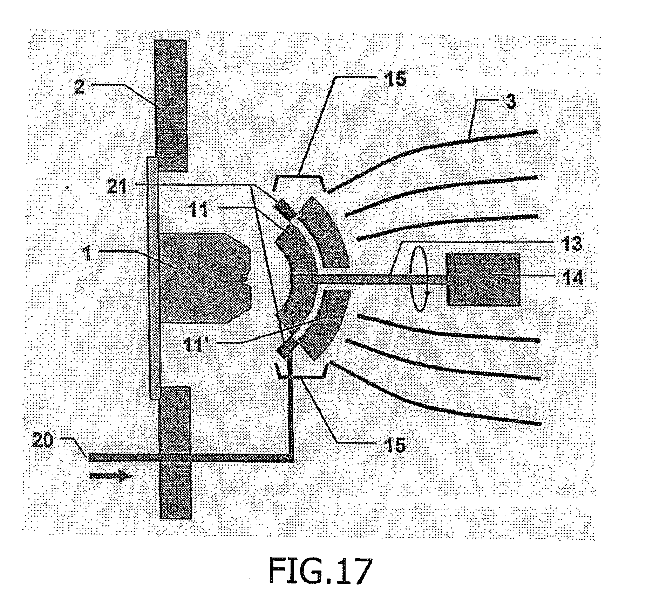

Das Reinigungsproblem kann dann dadurch gelöst werden, dass die Folienfalle 10 während des Betriebs in Rotation versetzt wird, siehe Fig. 16,17. Das auf den Lamellen der Folienfalle 10 abgelagerte flüssige Material wird dann durch die Zentrifugalkraft radial nach außen geschleudert und so von den Lamellen der Folienfalle 10 entfernt. Die Radialbeschleunigung ist dabei gegeben durch

$$a_r = r \cdot \omega^2.$$

Bei typischen Radien im Bereich von zum Beispiel 5 cm wird bereits bei einer Drehfrequenz von 7 Umdrehungen pro Sekunde eine Radialbeschleunigung von 10 g = 98.1 m/s$^2$ erreicht. Damit können flüssige Ablagerungen bis auf eine eventuell an den Folien haftende dünne Schicht nahezu vollständig nach außen geschleudert werden.

Ein weiterer Vorteil der Verwendung einer rotierenden Folienfalle 10 ist, dass größere Debris-Tröpfchen 45, die relativ geringe Geschwindigkeiten aufweisen, durch die Rotation von den Lamellen der Folienfalle 10 erfasst und so entfernt werden können. Bei einer Länge L der rotierenden Folienfalle 10 und einer Breite B der Kanäle in Umfangsrichtung können noch Tröpfchen mit einer Maximalgeschwindigkeit von

$$v_{max} = \omega \cdot r \cdot L / B$$

entfernt werden. Für typische Werte von r = 5cm, L/B = 10 ergibt sich bei einer Drehfrequenz von 7 Umdrehungen pro Sekunde eine Maximalgeschwindigkeit der zurückgehaltenen Partikel von 22 m/s.

Die rotierende Folienfalle 10 wirkt bei höherer Rotationsfrequenz wie eine Pumpe, die einen Gastransport hauptsächlich in radialer Richtung bewirkt. Dies hat einen Einfluss auf die Dichteverteilung des in der Folienfalle 10 verwendeten Puffergases 20. Zusätzlich wird auch der Strömungsleitwert der Fallenstruktur für eine axiale Durchströmung mit dem Puffergas 20 verändert.

Im Detail werden folgende Ausführungsformen einer rotierenden Folienfalle vorgeschlagen:

1. Rotation der gesamten Folienfalle 10 über eine Drehachse 13 durch einen Motor 14, siehe Fig.16,

2. Rotation nur eines Teils der Folienfalle 10 zum Beispiel durch eine zweistufige Folienfalle 10 gemäß Fig.17,

3. kreisförmiger, mitrotierender Auffänger bzw. Ring 15 zum Auffangen und zur definierten Abfuhr des radial beschleunigten Materials,

4. kreisförmig um die rotierende Folienfalle 10 angeordneter, statischer Ring 15 zum Auffangen und zur definierten Abfuhr des radial ausgeworfenen Materials,

5. Anordnung der Puffergaszufuhr auf der Rotationsachse der Folienfalle 10 derart, dass sich abhängig von der Rotationsfrequenz der Folienfalle 10 unter Berücksichtigung der radialen Pumpwirkung eine möglichst homogene Dichteverteilung des Puffergases 20 ergibt. Dies wird durch geeignete Wahl der axialen Ausströmpositionen im Bereich der Lamellen und der Gasflüsse erreicht.

6. Anordnung der Puffergaszufuhr im Raum zwischen Kollektor 3 und Folienfalle 10 an Positionen, die mit Bereichen im optischen Strahlengang korrespondieren, die durch weitere Systemkomponenten abgeschattet sind. Dadurch wird kein zusätzlicher Lichtverlust durch die Absaugeinrichtung selbst hervorgerufen. Anordnung und Gasflüsse werden so gewählt, dass sich abhängig von der Rotationsfrequenz der Folienfalle 10 unter Berücksichtigung der radialen Pumpwirkung eine möglichst homogene Dichteverteilung des Puffergases 20 ergibt.

Die beschriebenen Formen für die chemische Reinigung und den Betrieb einer Folienfalle 10 können mit anderen Maßnahmen zur Erhöhung der Lebensdauer der optischen Komponenten des Quellenmoduls kombiniert werden:

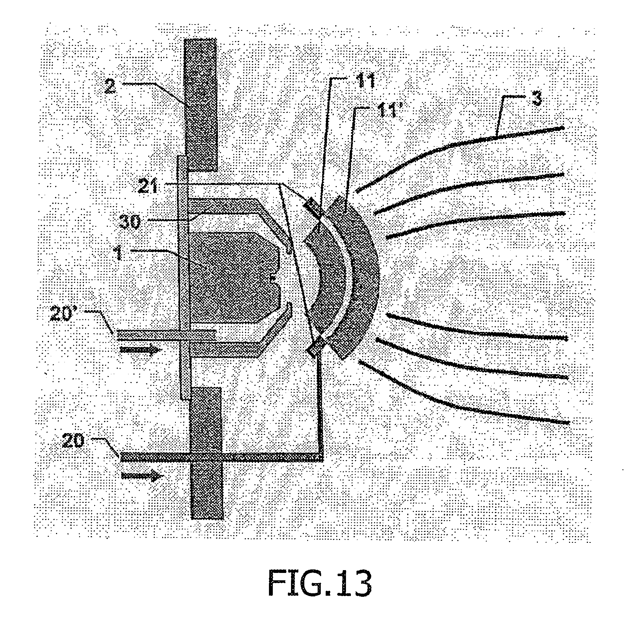

•  Zusätzliche Zufuhr eines Sperrgases 20' mit einer vom Puffergas 20 der Folienfalle 10 verschiedenen Gasart im Bereich der Strahlungsquelle 1. Dies führt zu einem Gegendruck im Bereich der Quelle 1 und zu einer Verminderung des Gasflusses von der Folienfalle 10 oder 11 und 11' (Fig.13) zur Quelle 1. Der Partialdruck des Folenfallen-Puffergases am Ort der Strahlungsquelle 1 wird dadurch vermindert. Dies ist von Vorteil, wenn der Betrieb der Strahlungsquelle 1 nur bei niedrigem Partialdruck des Folienfallen-Puffergases 20 möglich ist. Als Sperrgas können z.B. Wasserstoff, Stickstoff, Helium oder andere Edelgase, wahlweise auch in Mischungen verwendet werden.

- Zusätzliche Sperrgaszufuhr mit einer vom Puffergas 20 der Folienfalle 10 verschiedenen Gasart im Bereich des Kollektors 3. Dies führt zu einem Gegendruck im Bereich des Kollektors und zu einer Verminderung des Gasflusses von der Folienfalle 10 oder 11 und 11' zum Kollektor 3. Der Partialdruck des Folienfallen-Puffergases im Kollektorraum wird dadurch vermindert. Dies ist von Vorteil, wenn die strahlungsabsorbierende Wirkung des Folienfallen-Puffergases durch ein weniger absorbierendes Gas im Kollektorraum vermieden werden kann. Es können die im vorigen Abschnitt genannten Gase verwendet werden.

- Debris-Unterdrückung durch elektrische oder magnetische Felder. Hierdurch können geladene Partikel abgelenkt und in unschädliche Bereiche des Systems geleitet werden.

- Elektrische Isolation der Folienfalle 10 und/oder des Kollektors 3 gegenüber dem Vakuumgefäß. Hierdurch können Sekundärentladungen im Kollektorraum vermieden werden, die andernfalls zum Abtrag von Reflexionsschichten durch Sputtern führen können.

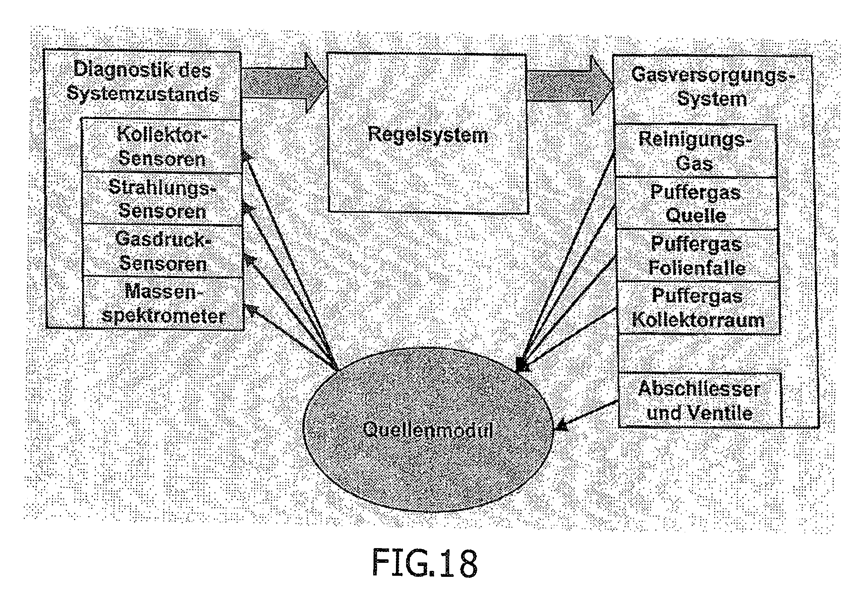

Für die Steuerung des Quellemoduls mit allen Komponenten zur Reinigung des Systems im Online- oder Offline-Betrieb wird ein komplexes Steuer - und Regelungssystem verwandt, was in Fig.18 angedeutet ist, das den Zustand der optischen Komponenten 43 und der Systeme zur Debris-Unterdrückung überwacht und die Reinigungsprozesse initialisiert und steuert.

Eine wichtige Komponente des Regelungssystems ist die ständige Messung des Verschmutzungsgrads der optischen Komponenten, zum Beispiel des Kollektors. Die Messung sollte bevorzugt an verschiedenen Stellen erfolgen, da der Verschmutzungsgrad ortsabhängig sein kann, und damit auch die Detektion, die Prozesssteuerung der Reinigung und die Erfolgskontrolle lokal erfolgen müssen.

Ein geeigneter Messparameter hierfür ist zunächst die Reflektivität der optischen Komponenten, möglichst bei der Wellenlänge des Lithographieprozesses, zum Beispiel EUV-Bereich, und möglichst auch unter dem für die optischen Komponenten typischen Einfallswinkel. Hierzu können zum Beispiel in Belichtungspausen, wie sie beim Wechsel von Wafern entstehen, geeignete EUV-Detektoren, wie zum Beispiel Dioden mit speziellen Filtern, in die Nähe der optischen Komponenten 43 gebracht werden, um die Intensität des an verschiedenen Stellen der optischen Komponenten reflektierten Lichtes zu messen.

Es ist auch möglich Strahlung anderer Wellenlänge, wie zum Beispiel sichtbare Strahlung, zu verwenden, um über Änderungen der Reflektivität Depositionen auf den optischen Komponenten 43 zu messen. Dies ist besonders vorteilhaft, wenn bei der Offline-Reinigung keine EUV-Quelle zur Verfügung steht.

Es gibt noch weitere Messprinzipien, die sowohl bei Online-Reinigung als auch bei Offline-Reinigung zur Messung von deponierten Schichten eingesetzt werden können. Mit Schichtdickenmessverfahren, wie z. B. Schwingquarzen oder auch ellipsometrischen Methoden können Vorhandensein und Dicke von Verunreinigungsschichten gemessen werden.

Durch Anlegen hochfrequenter Wechselspannung an die Oberfläche der optischen Komponenten kann deren Oberflächenleitfähigkeit bestimmt werden. Diese ist materialabhängig und lässt auf Oberflächenbelegungen zurückschließen. Sind die Leitfähigkeitsunterschiede zwischen dem Oberflächenmaterial und dem deponierten Material zu gering, so können in Nähe einer optischen Komponente Flächen eines Materials mit großem Leitfähigkeitsunterschied zur Verunreinigung (zum Beispiel Isolatormaterialien bei metallischen Verunreinigungen) angebracht werden, die in räumlicher Orientierung und Oberflächentemperatur der optischen Komponente ähneln. Damit lassen Depositionen auf diesen Messflächen direkt auf Depositionen auf der optischen Komponente zurückschließen.

Ein weiterer Messparameter ist ein Photostrom, der dadurch entsteht, dass Strahlungsquanten, die auf die Oberfläche einer optischen Komponente treffen, zu Elektronenemission führen. Auch Veränderungen in diesem Photostrom sind empfindliche Hinweise auf Änderungen der Oberflächenbelegung mit einer Verunreinigung.

Die Analyse der Gasphase im Vakuumsystem an unterschiedlichen Stellen liefert wertvolle Aufschlüsse zur Steuerung der chemischen Reinigung. Es gibt verschiedene Messverfahren, mit denen diese Analyse möglich ist. Als Beispiel sei hier vor allem die Massenspektrometrie genannt. Durch Messung der Partialdruckzusammensetzung können sowohl die flüchtigen Reaktionsprodukte als auch überschüssige Reaktionsgase nachgewiesen werden. Dies dient zum einen der Optimierung der Reinigungseffizienz. Es wird z.B. bei einer möglichst schonenden Reinigung das Verhältnis der Partialdrucke von Reaktionsprodukt und Reaktionsgas maximiert. In einem anderen Beispiel wird für eine möglichst schnelle Reinigung der Partialdruck des Reaktionsproduktes maximiert. Bei Offline-Reinigung kann das Reinigungsende durch Abnahme des Partialdruckes des Reaktionsproduktes nachgewiesen werden. Durch Partialdruckmessungen kann auch die Selektivität überwacht werden, indem nicht gewollte Reaktionsprodukte mit dem Material der optischen Komponente überwacht werden. In ähnlicher Weise kann die Vakuumqualität hinsichtlich Verunreinigungen durch Reaktionen mit anderen Komponenten des Vakuumsystems kontrolliert werden. Schließlich können über die Partialdruckmessungen die Regenerationszyklen von Sorptionspumpen gesteuert werden.

Die Steuerung der Gaszuführung von Reaktionsgasen kann über Ventile und Flusssteuerungen mit entsprechenden Flussmessern erfolgen. Dabei wird der resultierende Druck des Reaktionsgases durch lokale Partialdruckmessungen kontrolliert. Bei Reinigung mit Überschuss des Reaktionsgases genügt eine lokale Gesamtdruckmessung. Das Steuersystem für die Gaszufuhr erlaubt die Wahl zwischen unterschiedlichen Reaktionsgasen, die lokale Verteilung der Reaktionsgase, die Beimischung von Inertgas zur Diffusionsminderung und die Zuführung von zusätzlichen Reaktionsgasen zur Passivierung nicht zu reinigender Oberflächen.

Neben dem Gaseinlass stellen natürlich die Temperaturen sowohl der zu reinigenden als auch der nicht zu reinigenden Komponenten wichtige Steuerparameter dar. Außerdem wird die chemische Reinigung über die Dauer der Exposition mit dem Reaktionsgas gesteuert.

Das Verfahren und die Vorrichtung zum Reinigen von optischen Komponenten führen zu einer deutlich verbesserten Beseitigung von Ablagerungen und einer höheren Lebensdauer der optischen Komponenten.

BEZUGSZEICHENLISTE:

| | |
|---|---|
| 1 | Lampe |
| 2 | Vakuumkessel |
| 3 | Kollektor |
| 4 | Rohrleitung zur Pumpe |
| 5 | Zwischenfokus |
| 6 | Beispiel für optischen Strahlengang |
| 7 | System zur Debris-Unterdrückung |
| 10 | Folien-Falle |
| 11 | Doppel-Folienfalle |
| 12 | Absaugvorrichtung |
| 13 | Drehachse |
| 14 | Motor |
| 15 | Auffänger für entferntes Debris-Material |
| 20 | Puffergas-Zufuhr |
| 20' | Sperrgas |
| 21 | Ausströmdüsen für Puffergas |
| 30 | Lampengehäuse |
| 31 | Lampen-Abschließer |
| 32 | kollekterseitiger Abschließer |
| 33 | Abschließer zwischen Folienfalle und Kollektor |
| 34 | Montagering und äußere Dichtfläche |
| 35 | Zentralstück und innere Dichtfläche |
| 36 | bewegliche Abschließersegmente |
| 37 | Kühlvorrichtung |
| 40 | Reinigungsgas-Zufuhr |
| 41 | Ausströmdüsen für Reinigungsgas |
| 42 | Reinigungsgas |
| 43 | optische Komponente, z.B. Spiegel |
| 44 | EUV-Strahlung |
| 45 | Debris-Partikel |
| 46 | Deponierte Debris-Partikel, Debris-Material |
| 47 | flüchtige Reaktionsprodukte |
| 110 | optische Komponente |
| 112 | Bestrahlungseinrichtung |
| 114 | Vakuumkammer |
| 116 | Strahlungsquelle |
| 118 | Strahlen |

(fortgesetzt)

| 120 | Werkstück |
|---|---|
| 122 | anorganische Substanz |
| 124 | Reaktionspartner |
| 125 | Anregungseinrichtung |
| 126 | Zuführungseinrichtung |
| 128 | Ablagerungen |
| 130 | Reaktionsprodukt |
| 132 | Dosiereinrichtung |
| 134 | Messeinrichtung |
| 136 | Zuleitung |
| 138 | Kühlung |
| 140 | Düse |
| 142 | Beschichtung |
| 144 | Material |
| 146 | Heizeinrichtung |
| 148 | Sektoren |
| P | Vakuumpumpe |

**Patentansprüche**

1. Verfahren zum Reinigen mindestens einer optischen Komponente (110;43) von mindestens einer Bestrahlungseinrichtung (112), die in einer Vakuumkammer (114) mindestens eine insbesondere extrem-ultraviolette und/oder weiche Röntgenstrahlung erzeugenden Strahlungsquelle (116) aufweist, deren Strahlen (118) über die optische Komponente (110) auf ein zu bearbeitendes Werkstück (120) geleitet werden, wobei die optische Komponente (110) zumindest teilweise aufgrund einer durch die Strahlungsquelle (116) eingebrachte anorganische Substanz (122) mit ablagerungen dieser substanz verschmutzt wird, **dadurch gekennzeichnet, dass** mindestens ein bezüglich der Strahlen (118) im wesentlichen durchsichtiger bzw. transparenter Reaktionspartner (124) in Abhängigkeit von den herrschenden Reaktionsbedingungen über eine Zuführungseinrichtung (126) eingelassen wird, der mit den verschmutzenden Ablagerungen (128) zum Zwecke deren Beseitigung von der optischen Komponente (110) chemisch reagiert, wobei der Reaktionspartner (124) im Überschuss bezüglich einer eingetragenen Menge an anorganischer Substanz (122) und/oder den Ablagerungen (128) zugeführt wird oder mit einer Rate bis zur chemischen Äquivalenz bezüglich der eingetragenen Menge an anorganischer Substanz (122) und/oder Ablagerungen (128) über eine Dosiereinrichtung (132) zugeführt wird.

2. Verfahren nach Anspruch 1, **dadurch gekennzeichnet, dass** der Reaktionspartner (124) auf die optische Komponente (110) fokussiert wird.

3. Verfahren nach einem der Ansprüche 1 oder 2, **dadurch gekennzeichnet, dass** nicht zu reinigende Komponenten der Bestrahlungseinrichtung vor einer Beaufschlagung mit dem Reaktionspartner (124) geschützt werden.

4. Verfahren nach Anspruch 1, **dadurch gekennzeichnet, dass** die zu reinigenden optischen Komponenten (110,43) für die Dauer des Reinigungsvorgangs vom übrigen Vakuumsystem getrennt werden.

5. Verfahren nach einem der Ansprüche 1 bis 4, **dadurch gekennzeichnet, dass** die eingebrachte anorganische Substanz (122,45) zwischen der Strahlungsquelle (1) und dem Kollektor (3) mittels einer Folienfalle (10) unterdrückt wird.

6. Verfahren nach Anspruch 5, **dadurch gekennzeichnet, dass** Sperrgas (20') im Bereich der Strahlungsquelle (1) und/oder im Bereich des Kollektors (3) zugeführt wird, wobei das Sperrgas beispielsweise mindestens Wasserstoff, Stickstoff, Helium oder ein anderes Edelgas enthält.

7. Verfahren nach einem der Ansprüche 5 oder 6, **dadurch gekennzeichnet, dass** zur Unterdrückung von Ablagerungen (128, 45) elektrische und/oder magnetische Felder angelegt werden.

**8.** Verfahren nach einem der Ansprüche 1 bis 7, **dadurch gekennzeichnet, dass** das verfahren elektronisch gesteuert und geregelt wird.

**9.** Verfahren nach Anspruch 8, **dadurch** gekenntzeichnet, dass der Verschmutzungsgrad der optischen Komponente (110;43) bedarfsweise oder ständig gemessen wird.

**10.** Verfahren nach Anspruch 9, **dadurch gekennzeichnet, dass** der Verschmutzungsgrad an unterschiedlichen Orten gemessen wird.

**11.** Vorrichtung zum Reinigen mindestens einer optischen Komponente (110) von mindestens einer Bestrahlungseinrichtung (112), die in einer Vakuumkammer (114) mindestens eine insbesondere extrem-ultraviolette und/oder weiche Röntgenstrahlung erzeugende Strahlungsquelle (116) und eine optische Komponente (110) aufweist, die Strahlen (118) auf ein zu bearbeitendes Werkstück (120) leiten, wobei die optische Komponente (110) zumindest teilweise aufgrund einer durch die Strahlungsquelle (116) eingebrachte anorganische Substanz (122) verschmutzbar ist, **dadurch gekennzeichnet, dass** zur Beseitigung von den die optische Komponente (110) verschmutzenden Ablagerungen (128) eine Zuführungseinrichtung (126) vorhanden ist, die mindestens einen bezüglich der Strahlen (118) im wesentlichen durchlässigen bzw. transparenten Reaktionspartner (124) in Abhängigkeit von den herrschenden Reaktionsbedingungen eingibt, der mit den verschmutzenden Ablagerungen (128) eine chemische Reaktion eingeht, wobei der Reaktionspartner (124) im Überschuss oder mit einer Rate bis maximal zur chemischen Äquivalenz bezüglich einer eingetragenen Menge an anorganischer Substanz (122) und/oder den Ablagerungen (128) über eine Dosiereinrichtung (132) zuführbar ist oder

**12.** Vorrichtung nach Anspruch 11, **dadurch gekennzeichnet, dass** die Zuführungseinrichtung (126) eine Kühlung (138) und/oder eine Düse (140) aufweist.

**13.** Vorrichtung nach Anspruch 11, **dadurch** gekenntzeichnet, dass die mindestens eine optische Komponente (110) eine Heizeinrichtung (146) aufweist und/oder die nicht zu reinigenden Komponenten des Vakuumsystems heizbar oder kühlbar sind.

**14.** Vorrichtung nach einem der Ansprüche 11 bis 13, **dadurch gekennzeichnet, dass** zwischen der Strahlungsquelle (1) und dem Kollektor (3) eine Folienfalle (10) angeordnet ist.

**15.** Vorrichtung nach Anspruch 14, **dadurch gekennzeichnet, dass** die Folienfalle (10) oder ein Teil der Folienfalle (10) in Rotation versetzbar ist.

**16.** Vorrichtung nach Anspruch 15, **dadurch gekennzeichnet, dass** um den Rand der rotierbaren Folienfalle (10) ein stationärer oder in Rotation versetzbarer Auffänger (15) angeordnet ist

**17.** Vorrichtung nach Anspruch 14, **dadurch gekennzeichnet, dass** die Reinigung über eine elektronische Steuerung durchführbar ist.

**18.** Vorrichtung nach Anspruch 17, **dadurch gekennzeichnet, dass** mit an unterschiedlichen Orten angeordneten Einrichtungen der Verschmutzungsgrad der optischen Komponente (110;43) messbar ist.

**Claims**

**1.** A method for cleaning at least one optical component (110;43) of at least one radiotherapy device (112), which - in a vacuum chamber (114) - shows at least one particular radiation source (116) which generates extreme ultraviolet and / or soft radiation, whose beams (118) are directed to a workpiece to be processed (120) via the optical component (110), **characterized in that** the optical component (110) is (at least partly) contaminated with deposits of an inorganic substance (122) introduced by said radiation source (116), whereby at least one substantially translucent or transparent reactant (124) relative to the beams (118) is introduced via a feed means (as per the prevailing function conditions) which chemically reacts with the contaminating deposits (128) for the purpose of eliminating them from the optical component (110), whereby the reactant (124) is fed in excess compared to an entered amount of inorganic substance (122) and / or deposits (128) or at a rate which is up to the chemical equivalence compared to the inserted amount of inorganic substance (122) and or deposits (128) via a metering device (132).

2. The method according to claim 1, **characterized in that** the reactant (124) is focused on the optical component (110).

3. The method according to any one of claim 1 or claim 2, **characterized in that** not-to-purified components of the radiotherapy device are protected from exposure to the reactant (124).

4. The method according to claim 1, **characterized in that** the to-be-purified optical components (110,43) are separated from the rest of the vacuum system for the duration of the cleaning operation.

5. The method according to any one of claim1 to claim 4, **characterized in that** the introduced inorganic substance (122,45) is suppressed between the radiation source (1) and the collector (3) by means of a foil trap (10).

6. The method according to claim 5, **characterized in that** purge gas (20') is fed in the area of the radiation source (1) and / or in the gathering area (3), and contains e.g. and contains at least hydrogen, nitrogen, helium or another inert gas.

7. The method according to any one of claim 5 or claim 6, **characterized in that** electrical and / or magnetic fields are applied for the purpose of suppressing the formation of deposits (128, 45).

8. The method according to any one of claim 1 to claim 7, **characterized in that** the procedure is electronically controlled and regulated.

9. The method according to claim 8, **characterized in that** the degree of contamination of the optical component (110; 43) is measured as and when necessary, or continuously.

10. The method according to claim 9, **characterized in that** the degree of contamination is measured at different locations.

11. A device for cleaning at least one optical component (110) of at least one radiotherapy device (112), which - in a vacuum chamber (114) - shows at least one particular radiation source (116) which generates extreme ultraviolet and / or soft radiation and an optical component (110) whose beams (118) are directed to a workpiece to be processed (120) and whereby the optical component (110) is (at least partly) contaminated with deposits of an inorganic substance (122) introduced by said radiation source (116), **characterized in that** there is a feeder (126) available for the removal of the deposits (128) contaminating the optical component (110), which inserts at least one substantially transmissive or transparent reactant (124) with respect to the beams (118) (as per the prevailing function conditions) which chemically reacts with the contaminating deposits (128), whereby the reactant (124) is fed in excess or at a rate which is no more than the chemical equivalence compared to the inserted amount of inorganic substance (122) and or deposits (128) via a metering device (132).

12. The device according to claim 11, **characterized in that** the supply means (126) comprises a cooling system (138) and / or a nozzle (140).

13. The device according to claim 11, **characterized in that** the (at least single) optical component(s) (110) comprise (s) a heater (146) and / or the not-to-be-purified components of the vacuum system can be heated or cooled.

14. The device according to claim 11 to claim 13, **characterized in that** there is a foil trap (10) located between the radiation source (1) and the collector (3).

15. The device according to claim 14, **characterized in that** the foil trap (10) or a part thereof is set in rotation.

16. The device according to claim 15, **characterized in that** a collector (stationary or set in rotation) is to be located around the edge of the rotatable foil trap (10).

17. The device according to claim 14, **characterized in that** the purification is electronically controlled.

18. The device according to claim 17, **characterized in that** the contamination level of the optical component is measurable with devices at different locations.

**Revendications**

1. Procédé pour nettoyer au moins un composant optique (110 ; 43) d'au moins un système d'irradiation (112), comportant dans une chambre à vide (114) au moins une source de rayonnement (116) produisant notamment un rayonnement ultraviolet lointain et/ou un rayonnement X mou dont les rayons (118) sont dirigés par l'intermédiaire dudit composant optique (110) sur une pièce (120) à traiter, le composant optique (120) étant encrassé au moins partiellement par une substance inorganique (122) introduite par la source de rayonnement (116) par des dépôts de cette substance, **caractérisé en ce qu'**au moins un réactif (124) sensiblement translucide ou transparent vis-à-vis des rayons (118) est ajouté, en fonction des conditions de réaction régnantes, par l'intermédiaire d'un système d'amenée (126), ledit réactif réagissant chimiquement avec les dépôts (128) responsables de l'encrassement en vue de les éliminer dudit composant optique (110), le réactif (124) étant amené en excédent par rapport à une quantité introduite de substance inorganique (122) et/ou aux dépôts (128) ou à un taux allant jusqu'à l'équivalence chimique par rapport à la quantité introduite de substance inorganique (122) et/ou de dépôts (128) par l'intermédiaire d'un dispositif de dosage (132).

2. Procédé selon la revendication 1, **caractérisé en ce que** le réactif (124) est focalisé sur le composant optique (110).

3. Procédé selon l'une quelconque des revendications 1 ou 2, **caractérisé en ce que** des composants non à nettoyer du dispositif d'irradiation sont empêchés d'être soumis à l'effet du réactif (124).

4. Procédé selon la revendication 1, **caractérisé en ce que** les composants optiques (110, 43) à nettoyer sont séparés du reste du système à vide pendant toute la durée du nettoyage.

5. Procédé selon l'une quelconque des revendications 1 à 4, **caractérisé en ce que** la substance inorganique (122, 45) introduite entre la source de rayonnement (1) et le collecteur (3) est éliminée au moyen d'un piège à feuille (10).

6. Procédé selon la revendication 5, **caractérisé en ce qu'**un gaz d'arrêt (20') est amené dans la zone de la source de rayonnement (1) et/ou dans la zone du collecteur (3), le gaz d'arrêt contenant par exemple au moins de l'hydrogène, de l'azote, de l'hélium ou un autre gaz noble.

7. Procédé selon l'une quelconque des revendications 5 ou 6, **caractérisé en ce que** des champs électriques et/ou magnétiques sont appliqués pour éliminer les dépôts (128, 45).

8. Procédé selon l'une quelconque des revendications 1 à 7, **caractérisé en ce que** le procédé est commandé et contrôlé de manière électronique.

9. Procédé selon la revendication 8, **caractérisé en ce que** le degré d'encrassement du composant optique (110 ; 43) est mesuré en cas de besoin ou en permanence.

10. Procédé selon la revendication 9, **caractérisé en ce que** le degré d'encrassement est mesuré en différents endroits.

11. Dispositif pour nettoyer au moins un composant optique (110) d'au moins un système d'irradiation (112), comportant dans une chambre à vide (114) au moins une source de rayonnement (116) produisant notamment un rayonnement ultraviolet lointain et/ou un rayonnement X mou et un composant optique (110) dirigeant des rayons (118) sur une pièce (120) à traiter, le composant optique (120) étant encrassé au moins partiellement par une substance inorganique (122) introduite par la source de rayonnement (116), **caractérisé en ce que** pour éliminer les dépôts (128) responsables de l'encrassement du composant optique (110), un système d'amenée (126) ajoute au moins un réactif (124) sensiblement translucide ou transparent vis-à-vis des rayons (118) en fonction des conditions de réaction régnantes, ledit réactif réagissant chimiquement avec les dépôts (128) responsables de l'encrassement, le réactif (124) étant amené en excédent et/ou à un taux allant jusqu'au maximum l'équivalence chimique par rapport à une quantité introduite de substance inorganique (122) et/ou de dépôts (128), par l'intermédiaire d'un dispositif de dosage (132).

12. Dispositif selon la revendication 11, **caractérisé en ce que** le dispositif d'amenée (126) comprend un dispositif de refroidissement (138) et/ou une buse (140).

13. Dispositif selon la revendication 11, **caractérisé en ce que** le ou les composants optiques (110) comprennent un dispositif de chauffage (146) et/ou le ou les composants à nettoyer du système à vide peuvent être chauffés ou refroidis.

**14.** Dispositif selon l'une quelconque des revendications 11 à 13, **caractérisé en ce qu'**un piège à feuille (10) est disposé entre la source de rayonnement (1) et le collecteur (3).

**15.** Dispositif selon la revendication 14, **caractérisé en ce que** le piège à feuille (10) ou une partie du piège à feuille (10) peuvent être amenés en rotation.

**16.** Dispositif selon la revendication 15, **caractérisé en ce qu'**un collecteur (15) stationnaire ou pouvant être amené en rotation est disposé autour du bord du piège à feuille (10) rotatif.

**17.** Dispositif selon la revendication 14, **caractérisé en ce que** le nettoyage peut être mis en oeuvre par une commande électronique.

**18.** Dispositif selon la revendication 17, **caractérisé en ce que** le degré d'encrassement du composant optique (110 ; 43) peut être mesuré au moyen de dispositifs disposés en différents endroits.

FIG.1

FIG.2

EP 1 629 268 B1

FIG.3

FIG. 4

**FIG.5**

FIG.6

FIG.7

FIG.8

FIG.9

FIG.10

FIG.11

FIG.12

FIG.13

FIG.14

FIG.15

EP 1 629 268 B1

FIG.16

38

FIG.17

FIG.18

**EP 1 629 268 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10061248 A

- WO 02054115 A